# EUROPEAN PATENT APPLICATION

(11) **EP 4 596 183 A1**
(43) Date of publication of application: **06.08.2025**
(21) Application number: 23884482.3
(22) Date of filing: 15.09.2023
(51) Int. Cl.: B25J 11/00, B25J 19/00, B25J 5/00, B65G 1/04, B25J 9/16, B25J 9/02, B65G 47/00, B66F 9/07, F16M 11/04, F16M 11/18

(54) **OPERATION AND MAINTENANCE ROBOT**

(30) Priority: 31.10.2022 CN 202211350673
(71) Applicant: xFusion Digital Technologies Co., Ltd., Zhengzhou, Henan 450046 (CN)
(72) Inventor: HE, Risong, Zhengzhou, Henan 450046 (CN); LONG, Xingyun, Zhengzhou, Henan 450046 (CN)
(74) Representative: MERH-IP Matias Erny Reichl Hoffmann Patentanwälte PartG mbB
(86) International application number: PCT/CN2023/119256
(87) International publication number: WO 2024/093550

(57) **Abstract**

Embodiments of the present application provide an operation and maintenance robot. The operation and maintenance robot includes: a base; a first support member, including a first support body and a connecting part, where the connecting part is fixedly disposed on the first support body, and the first support body is fixed to the base; a second support member, including a second support body, a first sliding part and a second sliding part, where the second support body includes a first side surface and a second side surface, the first sliding part is fixedly disposed on the first side surface, the second sliding part is fixedly disposed on the second side surface, and the first sliding part is slidably connected to the connecting part, to enable the second support member to be close to or away from the base relative to the first support member; and an operation console, slidably connected to the second sliding part, capable of being close to or away from the base relative to the second support member. The operation and maintenance efficiency of the operation and maintenance robot provided in the present application is high.

## Description

This application claims priority to Chinese Patent Application No. 202211350673.0 filed with the China National Intellectual Property Administration on October 31, 2022, entitled "OPERATION AND MAINTENANCE ROBOT", which is incorporated herein by reference in its entirety.

### TECHNICAL FIELD

The present application relates to the field of robotic technologies, and in particular to an operation and maintenance robot.

### BACKGROUND

A data center refers to a facility used for accommodating computing devices and related components. As the data center industry thrives globally, there will be more and more large-scale data centers, and more and more computing devices requiring operations such as racking and de-racking, troubleshooting, hardware upgrading, and decommissioning. In order to free up operation and maintenance personnel and improve operational efficiency of the data centers, the operation and maintenance robots are used to operate and maintain the computing devices in the data centers. However, traditional operation and maintenance robots have low operational efficiency.

### SUMMARY

An embodiment of the present application provides an operation and maintenance robot with high operational efficiency.

According to a first aspect, an operation and maintenance robot is provided. The operation and maintenance robot includes:
a base;
a first support member, including a first support body and a connecting part, where the connecting part is fixedly disposed on the first support body, and the first support body is fixed to the base;
a second support member, including a second support body, a first sliding part and a second sliding part, where the second support body includes a first side surface and a second side surface, the first sliding part is fixedly disposed on the first side surface, the second sliding part is fixedly disposed on the second side surface, and the first sliding part is slidably connected to the connecting part, to enable the second support member to be close to or away from the base relative to the first support member; and
an operation console, slidably connected to the second sliding part, capable of being close to or away from the base relative to the second support member.

The first sliding part and the second sliding part in the embodiment are respectively fixedly disposed on the first side surface and the second side surface of the second support body. The first sliding part is slidably connected to the connecting part, to achieve a sliding connection between the second support member and the first support member. The second sliding part is slidably connected to the operation console, to achieve a sliding connection between the second support member and the operation console. That is, one side of the second support member is slidably connected to the first support member, and the other side is slidably connected to the operation console. The structure among the second support member, the first support member and the operation console is simple, which, to a certain extent, enables the operation and maintenance robot lighter and more convenient for rapid movement, thereby effectively improving the operation and maintenance efficiency of the operation and maintenance robot.

It is understandable that computing devices located in an equipment cabinet are at different heights of the equipment cabinet, and the operation console of the operation and maintenance robot needs to be at a same height as a computing device to be maintained, to facilitate operation of the computing device to be maintained. Therefore, the operation console of the operation and maintenance robot is configured to move within a height range that covers the heights of all computing devices in the equipment cabinet, so that operation and maintenance operations may be performed on each computing device.

In the embodiment, the operation console is movable relative to the second support member, and the second support member is movable relative to the first support member. That is, the operation console is movable relative to the first support member and the second support member, to facilitate adjusting the height based on the computing device to be maintained.

In addition, the second support member is movable relative to the first support member. When the second support member moves toward the base relative to the first support member until it can no longer move, the two support members (the first support member and the second support member) of the operation and maintenance robot are in a fully retracted state. In this case, the operation and maintenance robot is at its minimum height. When the second support member moves relative to the first support member away from the base until it can no longer move, the operation and maintenance robot is in a fully extended state. In this case, the operation and maintenance robot is at its maximum height. A state of the operation and maintenance robot between the fully retracted state and the fully extended state is referred to as a retracted state.

The first support member and the second support member in the embodiment of the present application are movable relative to each other. For example, the support members of the operation and maintenance robot are capable of extending and retracting. Therefore, the operation and maintenance robot may maintain a retracted state or a fully retracted state during movement, which lowers the center of gravity of the operation and maintenance robot, reduces security risk of the operation and maintenance robot, and conducive to the rapid progress of the operation and maintenance robot, thereby improving the operation and maintenance efficiency of the operation and maintenance robot. In addition, the operation and maintenance robot with lowered center of gravity makes it less prone to overturn during sharp brake and acceleration, ensuring security of the operation and maintenance robot.

Compared with an operation and maintenance robot with non-retractable support members, the operation and maintenance robot in the embodiment of the present application can enter an equipment room of a data center more conveniently due to its retractability, and also facilitate transportation, eliminating the use of hoisting or special ultra-high doors to enter the equipment room of the data center.

In a possible implementation, the first side surface and the second side surface are disposed facing away from each other. That is, the first sliding part and the second sliding part are disposed facing away from each other, to enable corresponding second support members to be connected to the first support member and the operation console on both sides of the second support members, respectively, resulting in a simple structure.

In a possible implementation, the first support body includes a first side rod, a second side rod, and a first connecting rod sequentially connected. The first side rod is parallel to the second side rod, and one end of the first side rod and one end of the second side rod that are away from the first connecting rod are fixed to the base. In other words, the first side rod and the second side rod are arranged in parallel and spaced from each other, one end of the first connecting rod is connected to one end of the first side rod, and the other end is connected to one end of the second side rod. One end of the first side surface and one end of the second side surface that are away from the first connecting rod are fixed to the base. The connecting part includes a first connecting part and a second connecting part. The first connecting part is fixedly disposed on the first side rod, and the second connecting part is fixedly disposed on the second side rod. A quantity of the first sliding parts is two, one of the first sliding parts is slidably connected to the first connecting part, and the other of the first sliding parts is slidably connected to the second connecting part.

In the implementation, the first connecting part and the second connecting part are spaced from each other on the first support body. The two connecting parts engage with the first sliding part of the second support member, compared with one connecting part engaging with the second support member, which ensures more balanced forces on the second support member when the second support member moves relative to the first support member, resulting in smoother movement.

In addition, the first support body in the embodiment consists of several rod bodies, which are lighter than plate bodies. This can, to a certain extent, lower the center of gravity of the operation and maintenance robot, thereby increasing stability during movement and operation of the operation and maintenance robot.

In a possible implementation, the second support body includes a third side rod, a fourth side rod, a third connecting rod, and a fourth connecting rod. The third side rod is arranged in parallel and spaced from the fourth side rod, the third connecting rod is connected between a first end of the third side rod and a first end of the fourth side rod, and the fourth connecting rod is connected between a second end of the third side rod and a second end of the fourth side rod. The first end of the third side rod and the first end of the fourth side rod are toward a same direction, and both toward the base, while the second end of the third side rod and the second end of the fourth side rod are toward a same direction, and both away from the base. In addition, the second support body in the embodiment consists of several rod bodies, which are lighter than plate bodies. this can, to a certain extent, lower the center of gravity of the operation and maintenance robot, thereby increasing stability during movement and operation of the operation and maintenance robot.

In a possible implementation, quantities of the first support members and the two second support members are two, the two first support members are disposed opposite to each other and spaced from each other, the two second support members correspond to the two first support members one to one, and are located between the two first support members, the operation console is located between the two second support members, and opposite sides of the operation console are respectively slidably connected to corresponding second support members.

It is understandable that the opposite sides of the operation console are slidably connected to the corresponding second support members. Compared with the first side or second side of the operation console being slidably connected to the second support member, this ensures balanced forces on both sides of the operation console, resulting in smoother movement of the operation console. Similarly, the operation console connects the two second support members together. When the second support members move relative to the first support members, the operation console and the two second support members are regarded as a whole. Opposite sides of the whole are respectively slidably connected to the two first support members. Compared with one side of the whole being slidably connected to the first support member, this ensures balanced forces on both sides of the whole, resulting in smoother movement. That is, the two second support members support one operation console, and the two first support members support the two second support members, resulting in smoother movement during extension and retraction of the support members of the operation and maintenance robot or during lifting and lowering of the operation console.

In a possible implementation, the operation and maintenance robot also includes a connecting plate. The connecting plate is connected to one end of each of the two second support members, each end being away from the base. In the implementation, the two second support members are connected by the connecting plate, so that the two second support members and the connecting plate constitute a whole. Compared with the solution in which the two second support members are not connected by the connecting plate, the architecture of the two second support members connected as a whole is more stable. this ensures that the support members of the operation and maintenance robot move more smoothly during the extension and retraction process, or the operation console moves more smoothly during the lifting and lowering process.

in a possible implementation, the operation and maintenance robot also includes a first drive assembly and a second drive assembly, the first drive assembly drives the second support body to be close to or away from the base relative to the first support body, and the second drive assembly drives the operation console to be close to or away from the base relative to the second support body.

in a possible implementation, a quantity of the first drive assemblies is two, one of the first drive assemblies is configured to drive one second support member to move relative to a corresponding first support member, and the other of the first drive assemblies is configured to drive the other second support assembly to move relative to a corresponding first support member. It can be understood that, the two second support members are connected by the operation console or the connecting plate, forming a whole. The two first drive assemblies can be understood as respectively driving opposite sides of the whole. Compared with driving one side of the whole, forces on the whole are more balanced, which facilitates smoother movement of the whole.

In a possible implementation, the first drive assembly includes a first screw rod, a first nut, and a first drive source. A first end of the first screw rod is rotatably connected to one end of the first support member close to the base, and a second end of the first screw rod is rotatably connected to one end of the first support member away from the base. The first nut is fixed to the second support member and rotatably connected to the first screw rod. The first drive source is connected to the first end of the first screw rod.

In a possible implementation, a portion of the first drive source is housed in the base, an output shaft of the first drive source is connected to the first end by a transmission belt. That is, the first drive source is indirectly connected to the first end of the first screw rod by the transmission belt, thus, it is convenient for the first drive source to be located in the holding space of the base. Compared with the first drive source being directly connected to the first end of the first screw rod, the embodiment not only ensures the neat appearance of the operation and maintenance robot but also ensures that the first drive source does not prevent the second support member from moving into the second avoidance groove of the base when the second support member moves toward the base, and in addition, facilitates miniaturization of the operation and maintenance robot.

In a possible implementation, the operation console includes an operation main body and a connecting plate assembly, the operation main body is slidably connected to the second sliding part by the connecting plate assembly, the operation and maintenance robot also includes a third drive assembly and a fourth drive assembly, the third drive assembly drives the operation console to move relative to the second support body, and drives the second support body to move relative to the first support body, and the fourth drive assembly drives the operation main body of the operation console to move relative to the second support body.

In a possible implementation, the third drive assembly includes a first pulley, a second pulley, a third pulley, a fourth pulley, a fifth pulley, a sixth pulley, a transmission member, and a first power source, the first pulley is mounted on one end of the first support member close to the base, the second pulley is mounted on one end of the first support member away from the base, the third pulley and the fourth pulley are mounted adjacent to each other on one side of the second support member toward the first support member, the third pulley is arranged close to the first pulley relative to the fourth pulley, the fifth pulley is mounted on one end of the second support member close to the base, and the sixth pulley is mounted on one end of the second support member away from the base; a first end of the transmission member is located between the first pulley and the third pulley, a second end of the transmission member is connected to the first end of the transmission member after sequentially wrapping around the first pulley, the second pulley, the fourth pulley, the sixth pulley, the fifth pulley, and the third pulley, a first side of the operation console is fixedly connected to the transmission member, and the first transmission source is connected to the first pulley.

In the implementation, the third drive assembly includes only one first power source, which achieves two-stage lifting and lowering of the operation and maintenance robot. Compared with the solution in which the two-stage lifting and lowering of the operation and maintenance robot is achieved by different first power sources respectively, an embodiment of the present application simplifies a structure of the third drive assembly, thereby effectively reducing cost.

In a possible implementation, the first screw rod or the transmission member is located between the first connecting part and the second connecting part. That is, the first screw rod or the transmission member is located between the first side rod and the second side rod. This ensures that when the first screw rod or the transmission member drives the second support member to move relative to the first support member, the second support member slides relative to the first side rod and the second side rod. Forces on both sides of the second support member in a width direction of the operation and maintenance robot are balanced, allowing the second support member to move more smoothly.

In a possible implementation, the base includes a top surface and a bottom surface disposed facing away from each other, a first avoidance groove is formed in the top surface, the first avoidance groove is located between two first support members, and the operation console is movable into the first avoidance groove.

The first avoidance groove is configured to avoid the operation console, so that the operation console can move as close as possible to the bottom surface of the operation console when moving toward the base. This enables the operation console to perform operation and maintenance operations on a computing device at a lower height (Figure).

It is understandable that the base needs a certain thickness to support all components mounted thereon, and to ensure stable movement of the operation and maintenance robot. However, the base with the certain thickness will affect a minimum height to which the operation console moves. That is, the thickness of the base will, to a certain extent, affect the minimum height to which the operation console moves, and for example, will, to a certain extent, affect the operation console to perform operation and maintenance operations on the computing device at a lower height. In the embodiment, the first avoidance groove is disposed on the top surface, which, on one hand, ensures that the operation console can move to a lower height, and on the other hand, ensures that the base is thick enough to ensure the stability of the operation and maintenance robot during movement.

In a possible implementation, two second avoidance grooves are formed in the top surface, one of the two second avoidance grooves is located between one of the first support members and the first avoidance groove, and is in communication with the first avoidance groove, and the other of the two second avoidance grooves is located between the other of the first support members and the first avoidance groove, and is in communication with the first avoidance groove; and a portion of the second support member is movable into a corresponding second avoidance groove. The second avoidance groove is configured to avoid the second support member. When the second support member moves toward the base relative to the first support member, a portion of the second support member can be received in the second avoidance groove, which enables the operation console to move into the first avoidance groove by the second support member.

According to a second aspect, another operation and maintenance robot is provided. The operation and maintenance robot includes:
a base, including a top surface and a bottom surface disposed facing away from each other, where a first avoidance groove is formed in the top surface and two second avoidance grooves, and the two second avoidance grooves are respectively located on opposite sides of the first avoidance groove, and are in communication with the first avoidance groove;
two first support members, where the two first support members are fixedly disposed on the top surface, and each of the two first support member is located on one side of one of the two second avoidance grooves, each side being away from the first avoidance groove, each of the first support members includes a first support body and a connecting part, the connecting part is fixedly disposed on the first support body, and the first support body is fixed to the top surface;
two second support members, where the two second support members are arranged opposite to the two second avoidance slots, respectively; each of the two second support member includes a second support body, a first sliding part and a second sliding part, the second support body includes a first side surface and a second side surface disposed facing away from each other, the first sliding part is fixedly disposed on the first side surface, and the second sliding part is fixedly disposed on the second side surface; the first sliding part of one of the second support members is slidably connected to a connecting part of one of the first support members, and the first sliding part of the other of the second support members is slidably connected to a connecting part of the other of the first support member, to enable the two second support members to be close to or away from the base relative to the two first support members, respectively, and portions of the two second support members are movable into corresponding second avoidance grooves; and
an operation console, where the second sliding parts of the two second support members are respectively connected to both sides of the operation console that face away from each other, the operation console is capable of being close to or away from the base relative to the two support members, and the operation console is movable into the first avoidance groove.

The technical effect brought by the operation and maintenance robot in the second aspect may refer to the technical effect brought by features in the corresponding implementations in the first aspect, which will not be repeated here.

### BRIEF DESCRIPTION OF DRAWINGS

In order to more clearly illustrate the technical solutions in the embodiments of the present application or in the background, the accompany drawings to be used in the embodiments of the present application or in the background will be described below.
FIG. 1 is a structural diagram illustrating a data center according to an embodiment of the present application;
FIG. 2 is a structural diagram illustrating an operation and maintenance robot according to an embodiment of the present application;
FIG. 3 is an exploded view illustrating the operation and maintenance robot shown in FIG. 2;
FIG. 4 is a structural diagram illustrating the operation and maintenance robot shown in FIG. 2 in another state;
FIG. 5 is a structural diagram illustrating the base in the structure shown in FIG. 3;
FIG. 6 is a structural diagram illustrating an operation console of the operation and maintenance robot shown in FIG. 4 in another state;
FIG. 7 is a structural diagram illustrating the base shown in FIG. 5 from another perspective;
FIG. 8 is a sectional view illustrating a portion of the structure shown in FIG. 7;
FIG. 9 is a structural diagram illustrating the first support member and other parts of the structure shown in FIG. 2 from a perspective;
FIG. 10 is a structural diagram illustrating the structure shown in FIG. 9 from another perspective;
FIG. 11 is a structural diagram illustrating a first connecting part in the structure shown in FIG. 10;
FIG. 12 is a structural diagram illustrating an auxiliary support body in the structure shown in FIG. 9;
FIG. 13 is a structural diagram illustrating a second support member and other parts of the operation and maintenance robot shown in FIG. 2;
FIG. 14 is a structural diagram illustrating the structure shown in FIG. 13 from another perspective;
FIG. 15 is a structural diagram illustrating a first sliding part in the structure shown in FIG. 13;
FIG. 16 is a structural diagram illustrating the structure shown in FIG. 15 in another embodiment;
FIG. 17 is a structural diagram illustrating a second connecting part in the structure shown in FIG. 13;
FIG. 18 is a structural diagram illustrating the structure shown in FIG. 17 in another embodiment;
FIG. 19 is a structural diagram illustrating an operation console in the structure shown in FIG. 2;
FIG. 20 is an exploded view illustrating the structure shown in FIG. 19;
FIG. 21 is a schematic diagram illustrating part of the structure of another operation and maintenance robot according to an embodiment of the present application;
FIG. 22 is a schematic diagram illustrating part of the structure shown in FIG. 21;
FIG. 23 is a structural diagram illustrating the structure shown in FIG. 22 in another state;
FIG. 24 is a structural diagram illustrating the structure shown in FIG. 23 in another structure;
FIG. 25 is a structural diagram illustrating the structure shown in FIG. 24 in another state;
FIG. 26 is a structural diagram illustrating the structure shown in FIG. 24 in another state; and
FIG. 27 is a schematic diagram illustrating part of the structure shown in FIG. 23.

### DESCRIPTION OF EMBODIMENTS

The following describes the embodiments of the present application with reference to the accompany drawings.

In the description of the embodiments of the present application, it should be noted that, unless otherwise specified and limited, the terms "mounted" and "connected" are to be understood in a broad sense. For example, "connected" may be detachably connected or non-detachably connected, or may be directly connected or indirectly connected by an intermediate medium. "fixedly connected" refers to being connected to each other and maintaining a relative position unchanged after being connected. "Rotatably connected" refers to being connected to each other and being capable of rotating relative to each other after being connected. "slidably connected" refers to being connected to each other and being capable of sliding relative to each other after being connected. The orientation terms mentioned in the embodiments of the present application, such as "up", "down", "inner" and "outside", only refer to the directions in the accompanying drawings. Therefore, the use of orientation terms is for the purpose of better and more clearly explaining and understanding the embodiments of the present application, rather than indicating or implying that the apparatus or element referred to must have a specific orientation, be constructed and operated in a specific orientation. Thus, it cannot be understood as a limitation on the embodiments of the present application. "a plurality of" refers to two or more.

It is understandable that the specific embodiments described herein are only used to explain related inventions, and are not intended to limit the present invention. It should also be noted that, for the sake of description, only parts related to the present invention are shown in the accompanying drawings.

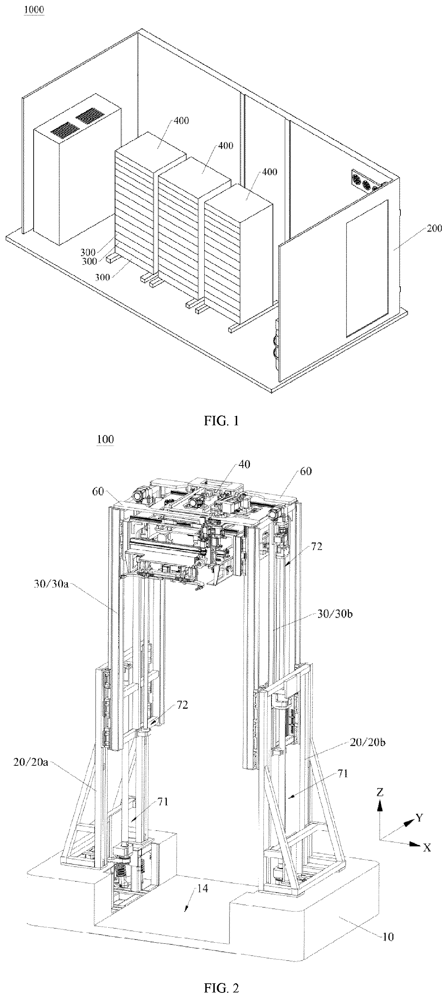

With reference to FIG. 1, FIG. 1 is a schematic structural diagram of a data center 1000 according to an embodiment of the present application.

As shown in FIG. 1, the data center 1000 is a globally-collaborated network of a device, which is used to transfer, accelerate, display, compute and store data information over an Internet infrastructure. The data center 1000 may include a computing device 300 and devices associated with the computing device 300, such as data communication connection devices, environmental control devices, power supply devices, monitoring devices, and security devices. The computing device 300 and the devices associated with the computing device 300 are all located in an equipment room 200.

As shown in FIG. 1, the data center 1000 may also include an equipment cabinet 400. The computing device 300 and related devices may be located in the equipment cabinet 400. Generally, a quantity of the computing devices 300 may be a plurality. The plurality of computing devices 300 may be located in different equipment cabinets 400. A quantity of the equipment cabinets 400 may include, but is not limited to, 3 shown in FIG. 1. For example, 50 to 100 equipment cabinets 400 may be included.

In the embodiment, the computing devices 300 include, but are not limited to, servers, switches, routers, storage devices, workstations, and/or other devices placed in the equipment cabinets, etc. The servers may be tower servers, blade servers, and/or rack servers, etc.

With reference to FIGS. 1 and 2, FIG. 2 is a schematic diagram of a structure of an operation and maintenance robot according to an embodiment of the present application.

The data center 1000 may also include an operation and maintenance robot 100. The operation and maintenance robot 100 is configured to maintain the computing device 300 in the data center 1000 in place of maintenance personnel. For example, the operation and maintenance robot 100 may remove the computing device 300 from the equipment cabinet 400, perform troubleshooting, hardware upgrading, and other operations on the computing device 300, and reinstall the computing device 300 into the equipment cabinet 400. Alternatively, the operation and maintenance robot 100 may replace an old or faulty computing device 300 in the equipment cabinet 400 with a new computing device 300. The operation and maintenance robot 100 maintains the computing device 300, which frees up operation and maintenance manpower, thereby improving the operational efficiency of the data center 1000.

It should be noted that in another embodiment, the operation and maintenance robot 100 shown in FIG. 2 may also be used for maintaining other electronic devices located outside the computing device 300, or may also be used for material allocation in a warehouse. The operating environment of the operation and maintenance robot 100 is not limited in the embodiment of the present application.

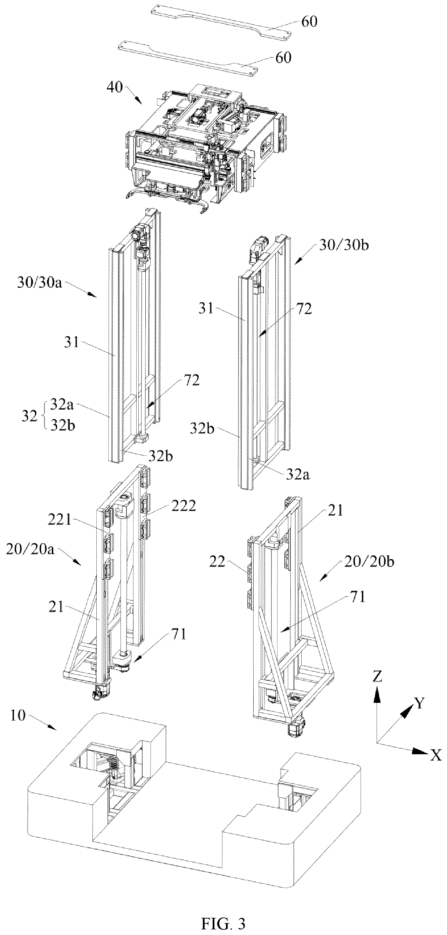

With reference to FIGS. 2 and 3, FIG. 3 is a schematic diagram of a decomposed structure of the operation and maintenance robot shown in FIG. 2.

The operation and maintenance robot 100 may include a base 10, a first support member 20, a second support member 30, and an operation console 40. The first support member 20 may include a first support body 21 and a connecting part 22, the connecting part 22 is fixedly disposed on the first support body 21, and the first support body 21 is fixed to the base 10. The second support member 30 may include a second support body 31 and a sliding part 32, the sliding part 32 may include a first sliding part 32a and a second sliding part 32b, the second support body 31 includes a first side surface and a second side surface, the first sliding part 32a is fixedly disposed on the first side surface, and the second sliding part 32b is fixedly disposed on the second side surface. The first sliding part 32a is slidably connected to the connecting part 22, so that the second support member 30 may move relative to the first support member 20, thereby moving close to or away from the base 10. The operation console 40 is slidably connected to the second sliding part 32b, so that the operation console 40 may move relative to the second support member 30, thereby moving close to or away from the base 10. The operation console 40 is configured to perform related operations on a computing device 300 to be maintained.

It is understandable that the computing devices 300 in the equipment cabinet 400 are located at different heights of the equipment cabinet. The operation console 40 of the operation and maintenance robot 100 needs to be at a same height as the computing device 300 to be maintained, to facilitate the operation of the computing device 300 to be maintained. Therefore, the operation console 40 of the operation and maintenance robot 100 is configured to move within a height range that covers all computing devices 300 in the equipment cabinet 400, so that maintenance operation can be performed on each computing device 300.

In the embodiment, the operation console 40 is movable relative to the second support member 30, and the second support member 30 is movable relative to the first support member 20. That is, the operation console 40 is movable relative to the first support member 20 and the second support member 30, to facilitate adjusting the height based on the computing device 300 to be maintained.

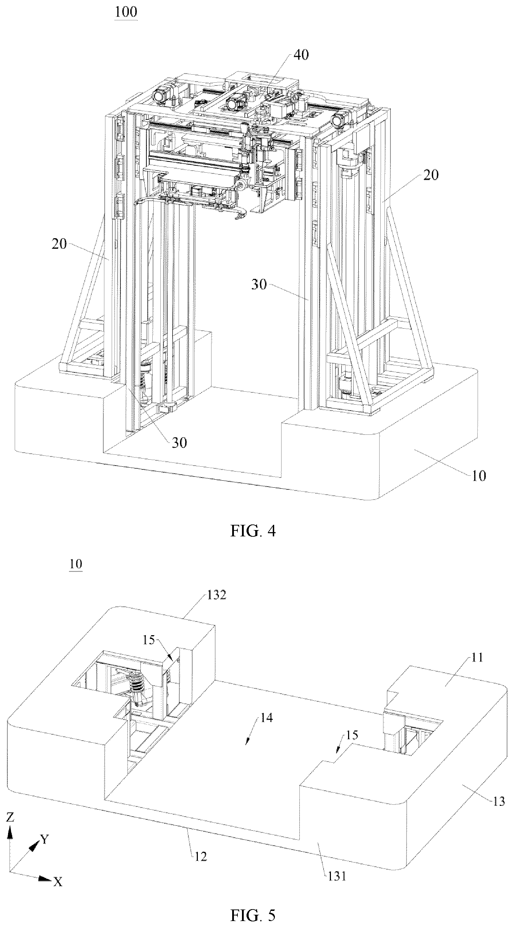

In addition, the second support member 30 is movable relative to the first support member 20. When the second support member 30 moves toward the base 10 relative to the first support member 20 until it can no longer move, the two support members (the first support member 20 and the second support member 30) of the operation and maintenance robot 100 are in a fully retracted state (as shown in FIG. 4). In this case, the operation and maintenance robot 100 is at its minimum height. When the second support member 30 moves relative to the first support member 20 away from the base 10 until it can no longer move, the operation and maintenance robot 100 is in a fully extended state (as shown in FIG. 2). In this case, the operation and maintenance robot 100 is at its maximum height. A state of the operation and maintenance robot 100 between the fully retracted state and the fully extended state is referred to as a retracted state.

The first support member 20 and the second support member 30 in the embodiment of the present application are movable relative to each other. For example, the support members of the operation and maintenance robot 100 are capable of extending and retracting. Therefore, the operation and maintenance robot 100 can maintain a retracted state or a fully retracted state during movement, which lowers the center of gravity of the operation and maintenance robot 100, thereby reducing its security risks and facilitates rapid movement, thereby improving the operation and maintenance efficiency of the operation and maintenance robot 100. In addition, the lowered center of gravity of the operation and maintenance robot 100 makes it less prone to overturn during sharp brake and acceleration, ensuring security of the operation and maintenance robot 100.

Compared with an operation and maintenance robot 100 with non-retractable support members, the operation and maintenance robot 100 in the embodiment of the present application can enter the equipment room of the data center more conveniently due to its retractability, and also facilitates transportation, eliminating the use of hoisting or special ultra-high doors to enter the equipment room of the data center.

In addition, the first sliding part 32a and the second sliding part 32b in the embodiment are respectively fixedly disposed on the first side surface and the second side surface of the second support body 31. The first sliding part 32a is slidably connected to the connecting part 22, to achieve a sliding connection between the second support member 30 and the first support member 20. The second sliding part 32b is slidably connected to the operation console 40, to achieve a sliding connection between the second support member 30 and the operation console 40. That is, one side of the second support member 30 is slidably connected to the first support member 20, and the other side is slidably connected to the operation console 40. The structure among the second support member 30, the first support member 20 and the operation console 40 is simple, which to a certain extent enables the operation and maintenance robot 100 lighter and more convenient for rapid movement, thereby effectively improving the operation and maintenance efficiency of the operation and maintenance robot 100.

Of course, in other embodiments, the operation and maintenance robot 100 may also include more than two support members (the first support member 20 and the second support member 30). The operation and maintenance robot 100 may include more than two support members among which two adjacent support members may be extended and retracted from each other. Therefore, the operation and maintenance robot 100 may retract the more than two support members during movement or transportation, so that the operation and maintenance robot 100 is in a retracted state or a fully retracted state, which facilitates safe movement, improves the operation and maintenance efficiency, or is convenient for transportation.

With reference to FIGS. 2, 3, and 5, FIG. 5 is a structural diagram illustrating a base in the structure shown in FIG. 3.

Hereinafter, for the convenience of description, as shown in FIG. 2, the length direction of the operation and maintenance robot 100 is defined as the X-axis direction, the width direction of the operation and maintenance robot 100 is defined as the Y-axis direction, and the height direction of the operation and maintenance robot 100 is defined as the Z-axis direction, where the X direction, Y direction, and Z direction are mutually perpendicular to each other in pairs.

In the embodiment, as shown in FIGS. 2 and 5, the base 10 is configured to support the first support member 20, the second support member 30, and the operation console 40. The base 10 may include a top surface 11 and a bottom surface 12 disposed facing away from each other, a peripheral side surface 13 connected between the top surface 11 and the bottom surface 12, a first avoidance groove 14, and a second avoidance groove 15. The first avoidance groove 14 and the second avoidance groove 15 are formed in the top surface 11, and the second avoidance groove 15 is in communication with the first avoidance groove 14.

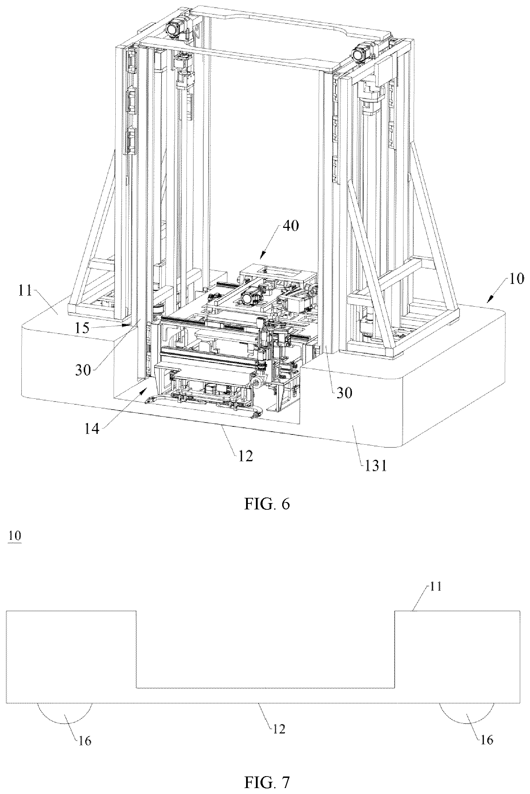

As shown in FIG. 6, the first avoidance groove 14 is configured to avoid the operation console 40, so that the operation console 40 can move as close as possible to the bottom surface 12 of the operation console 40 when moving toward the base 10. This enables the operation console 40 to perform operation and maintenance operations on a computing device 300 at a lower height (FIG. 1). The second avoidance groove 15 is configured to avoid the second support member. When the second support member 30 moves toward the base 10 relative to the first support member 20, a portion of the second support member 30 can be received in the second avoidance groove 15, which enables the operation console 40 to move into the first avoidance groove 14 by the second support member 30.

It is understandable that the base 10 needs a certain thickness to support all components mounted thereon, and to ensure stable movement of the operation and maintenance robot 100. However, the base 10 with the certain thickness will affect a minimum height to which the operation console 40 moves. That is, the thickness of the base 10 will, to a certain extent, affect the minimum height to which the operation console 40 moves, and for example, will, to a certain extent, affect the operation console 40 to perform operation and maintenance operations on the computing device 300 at a lower height. In the embodiment, the first avoidance groove 14 is disposed on the top surface 11, on one hand, which ensures that the operation console 40 can move to a lower height, and on the other hand, ensures that the base 10 is thick enough to ensure stability of the operation and maintenance robot 100 during movement.

As shown in FIGS. 5 and 6, for example, the peripheral side surface 13 may include a first side surface 131 and a second side surface 132 disposed opposite to each other in the Y direction. The first side surface 131 and the second side surface 132 form openings in communication with the first avoidance groove 14, so that a component of the operation console 40 for operating the computing device 300 can extend out of the first avoidance groove 14 through an opening of the first side surface 131 to operate a corresponding computing device 300. In other embodiments, only the first side surface 131 is formed with an opening in communication with the first avoidance groove 14, so that the component of the operation console 40 for operating the computing device 300 can extend out of the first avoidance groove 14.

Of course, in an implementation scenario of other embodiments, the bottom surface 12 may also be provided with only a first avoidance groove and may not be provided with a second avoidance groove. The operation console 40 may be slidably connected to the second support body 31 of the second support member 30 by a connector. When the second support member 30 moves close to the top surface 11 relative to the first support body 21, the operation console 40 is located in the first avoidance groove 14.

In another implementation scenario of other embodiments, the top surface 11 may also not be provided with the first avoidance groove and the second avoidance groove, and the component of the operation console 40 for operating the computing device 300 are bent toward the bottom surface 12. This ensures that the operation console 40 can perform operation and maintenance operations on the computing device 300 at a lower height in a case of being not close to the bottom surface 12.

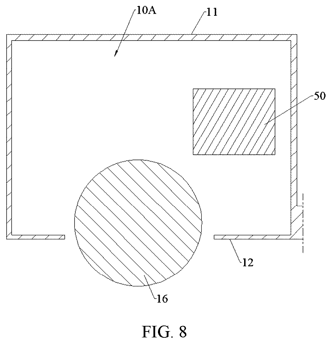

With reference to FIGS. 5, 7, and 8, FIG. 7 is a structural diagram illustrating the base shown in FIG. 5 from another perspective. FIG. 8 is a sectional view illustrating a portion of the structure shown in FIG. 7.

In the embodiment, the bottom surface 12 of the base 10 is provided with a moving wheel 16. The moving wheel 16 is configured to drive the operation and maintenance robot 100 to move, so as to perform operation and maintenance operations on different computing devices 300. In some embodiments, the receiving space 10A is formed between the top surface 11 and the bottom surface 12 to receive components such as a mobile controller 50 and a control board for the operation and maintenance robot 100. A portion of the moving wheel 16 may be received in the receiving space 10A and a portion extends out of the bottom surface 12 to contact the ground. The moving controller 50 is configured to control the moving wheel 16, enabling the operation and maintenance robot 100 to move toward a predetermined direction.

It is understandable that the portion of the moving wheel 16 is received in the receiving space 10A, which not only facilitates connection with the mobile controller 50 but also allows for an overlap with the base 10 in the thickness direction. This ensures that the bottom surface 12 is as close to the ground as possible, thereby enabling the operation console 40 to perform operation and maintenance operations on the computing device 300 at a lower height. It should be noted that a thickness direction of the base 10 is the height direction of the operation and maintenance robot 100 (Z direction). Of course, in other embodiments, the moving wheel 16 may also be directly provided on the bottom surface 12 of the base 10, and not located in the receiving space.

In some embodiments, the operation and maintenance robot 100 may also include an information transceiving unit (not shown in the figures). The information transceiving unit is configured to receive an operation and maintenance task transmitted by a background device and transmit a completion status of the operation and maintenance task to the background device. The background device may be an electronic device such as a computer, tablet, or mobile terminal that is capable of transmitting control information.

Of course, in some embodiments, the operation and maintenance robot 100 may also include a display screen. An operator may observe statuses of the operation and maintenance robot 100 on the display screen, such as a working status, travel route, live location, and so on of the operation and maintenance robot 100. The operation and maintenance task may also be assigned to the operation and maintenance robot 100 on the display screen.

With reference to FIGS. 2 and 5, in the embodiment, quantities of the first support members 20 and the second support members 30 are two. For ease of differentiation, the two first support members are designated as first support members 20a and 20b, and the two second support members are designated as second support members 30a and 30b. The first support members 20a and 20b are disposed opposite to each other and spaced from each other, and are respectively located on both sides of the first avoidance groove 14. For example, the first support members 20a and 20b are respectively located on both sides of the first avoidance groove 14 in the X direction, that is, the first avoidance groove 14 is located between the first support members 20a and 20b. Correspondingly, a quantity of the second avoidance grooves 15 is two, one of the second avoidance grooves 15 is located between the first support member 20a and the first avoidance groove 14, and is in communication with the first avoidance groove 14, and the other of the second avoidance grooves 15 is located between the first support member 20b and the first avoidance groove 14, and is in communication with the first avoidance groove 14.

In the embodiment, the first support members 20a and 20b being disposed opposite to each other can be understood as the first support members 20a and 20b being disposed opposite to each other in a mirror-image configuration. Of course, in other embodiments, the first support members 20a and 20b may be configured that portions of their structures are disposed in a mirror-image configuration.

The second support member 30a is slidably connected to the first support member 20a, the first support member 20a is slidably connected to the second support member 30b, and the two second support members 30 are located between the two first support members 20. The operation console 40 is located between the second support member 30a and the second support member 30b, and opposite sides (the first side and the second side) of the operation console 40 are respectively slidably connected to the second support member 30a and the second support member 30b. In other words, the first side and the second side of the operation console 40 are respectively slidably connected to the second support member 30a and the second support member 30b.

It is understandable that, the opposite sides of the operation console 40 are slidably connected to corresponding second support members 30, and compared with the first or second side of the operation console 40 being slidably connected to the second support members 30, this ensures balanced forces on both sides of the operation console 40, resulting in smoother movement of the operation console 40. Similarly, the operation console 40 connects the two second support members 30. When the second support members 30 move relative to the first support members 20, the operation console 40 and the two second support members 30 are regarded as a whole. Opposite sides of the whole are respectively slidably connected to the two first support members 20. Compared with one side of whole being slidably connected to the first support members 20, this ensures balanced forces on both sides of the whole, resulting in smoother movement of the whole. That is, the two second support members 30 support one operation console 40, and the two first support members 20 support the two second support members 30, resulting in smoother movement during extension and retraction of the support members of the operation and maintenance robot 100 or during lifting and lowering of the operation console 40.

Of course, in other embodiments, quantities of the first support members 20 and the second support members 30 may also be one. The one second support member 30 is slidably connected to the first support member 20, and a first side or second side of the operation console 40 is slidably connected to the second support member 30. In an implementation, one first support member 20 may be fixed to one side of the first avoidance groove 14.

In another implementation, the base 10 may not be provided with the first avoidance groove. The first support member 20 may be arranged close to the peripheral side surface 13 of the base 10, and the second support member 30 is slidably connected to one side of the first support member 20 close to the peripheral side surface 13. When the second support member 30 moves close to the base 10 relative to the first support member 20, a portion of the second support member 30 can extend out of one end of the first support member 20 close to the base 10, and is arranged opposite to the side surface of the base 10. This allows the end of the second support member 30 close to the base 10 to move from the top surface 12 of the base 10 to be as close as possible to the bottom surface 12 of the base 10, thereby facilitating the second support member 30 to drive the operation console 40 to perform operation and maintenance operations on the computing device 300 at a lower height.

In other embodiments, the quantities of the first support members 20 and the second support members 30 may also all be three. The three first support members 20 may be respectively arranged on three sides of the first avoidance groove 14. The second support members 30 are slidably connected to corresponding first support members 20 one to one. The three sides of the operation console 40 are slidably connected to corresponding second support members 30, to ensure that the support members of the operation and maintenance robot 100 move more smoothly during the extension and retraction process or the operation console 40 moves more smoothly during the lifting and lowering process. Of course, the quantities of the first support members 20 and the second support members 30 are not limited in the embodiment of the present application, and may be more than three.

In the embodiment, as shown in FIGS. 2 and 3, the operation and maintenance robot 100 may also include a connecting plate 60. The connecting plate 60 is connected to one end of the second support member 30a and one end of the second support member 30b that are away from the base 10. In the embodiment, the second support member 30a and the second support member 30b are connected by the connecting plate 60, and the second support member 30a, the second support member 30b, and the connecting plate 60 constitute a whole. Compared with the solution in which the second support member 30a and the second support member 30b are not connected by the connecting plate 60, the architecture of the second support member 30a and the second support member 30b connected as a whole is more stable. This ensures that the support members of the operation and maintenance robot 100 move more smoothly during the extension and retraction process, or the operation console 40 moves more smoothly during the lifting and lowering process.

For example, in the embodiment, for example, a quantity of the connecting plates 60 is two. The two connecting plates 60 are spaced from each other. An avoidance space is formed between the two connecting plates 60. When the operation console 40 moves relative to the second support member 30 away from the base 10 until it can no longer move, some components of the operation console 40 extend out through the avoidance space. That is, the connecting plates 60 and the operation console 40 partially overlap in the Z direction, thereby facilitating miniaturization of the operation and maintenance robot 100 in the Z direction.

Of course, in other embodiments, the quantity of the connecting plates 60 may be one, or more. When the quantity of the connecting plates 60 is one, the width of the one connecting plate 60 may be same as that of the second support member 30, or may be less than that of the second support member 30. The width of the connecting plate 60 is the length of the connecting plate 60 in the Y direction. When the quantity of the connecting plates 60 is a plurality, the plurality of connecting plates 60 may be spaced from each other. Of course, in some embodiments, the operation and maintenance robot 100 may also not include a connecting plate.

In some embodiments, to ensure the lower center of gravity of the operation and maintenance robot 100, a plurality of weight-reducing holes (not shown in the figures) may be formed in the connecting plates 60.

It is understandable that the structures of the two first support members 20 may be identical or different. In the embodiment, architectures of the two first support members 20 are same. The following description will be made by taking one of the first support members 20 for example.

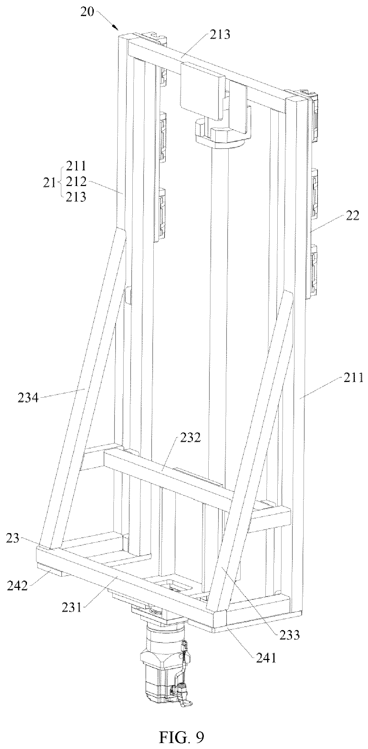

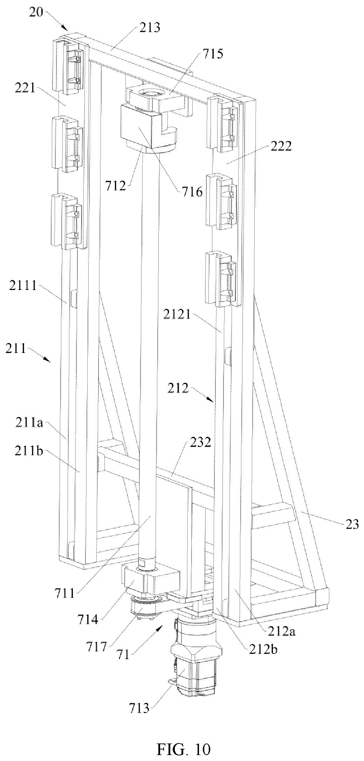

With reference to FIGS. 2, 9, and 10. FIG. 9 is a structural diagram illustrating the first support member and other parts of the structure shown in FIG. 2 from a perspective, and FIG. 10 is a structural diagram illustrating the structure shown in FIG. 9 from another perspective.

The first support body 21 of the first support member 20 may include a first side rod 211, a second side rod 212, and a first connecting rod 213. The first side rod 211 is arranged in parallel and spaced from the second side rod 212, one end of the first connecting rod 213 is connected to one end of the first side rod 211, and the other end is connected to one end of the second side rod 212. One end of the first side rod 211 and one end of the second side rod 212 that are away from the first connecting rod 213 are fixed to the top surface 11 of the base 10. The first support body 21 in the embodiment consists of several rod bodies, which are lighter than plate bodies. This can, to a certain extent, lower the center of gravity of the operation and maintenance robot 100, thereby increasing stability during movement and operation of the operation and maintenance robot 100.

In the embodiment, the first side rod 211 may include a first connecting surface 2111, the second side rod 212 may include a second connecting surface 2121, and the first connecting surface 2111 and the second connecting surface 2121 may face toward the first avoidance groove 14. In the embodiment, the connecting part 22 may include a first connecting part 221 and a second connecting part 222. The first connecting part 221 is fixedly disposed on the first connecting surface 2111, and the second connecting part 222 is fixedly disposed on the second connecting surface 2121. Therefore, the first connecting part 221 and the second connecting part 222 are spaced from each other on the first support body 21. The first connecting part 221 and the second connecting part 222 engage with the first sliding part 32a of the second support member 30, allowing the second support member 30 to move relative to the first support member 20.

It is understandable that, in the embodiment, the first connecting part 221 and the second connecting part 222 are spaced from each other on the first support body 21, the two connecting components 22 engage with the first sliding part 32a of the second support member 30. Compared with one connecting part 22 engaging with the second support member 30, this ensures more balanced forces on the second support member 30 during its movement relative to the first support member 20, resulting in smoother movement.

Of course, in other embodiments, the first support member 21 may also include only the first side rod 211, without the second side rod and the first connecting rod. In this case, the connecting part 22 includes only the first connecting part 221, the first connecting part 221 is connected to the first connecting surface 2111 of the first side rod 211, and the first connecting part 221 engages with the first sliding part 32a of the second support member 30. Alternatively, the first support body 21 may also be replaced by a plate body. Alternatively, a quantity of at least one of the first side rods 211 or the second side rods 212 is two or more. In this case, a quantity of the connecting parts 22 corresponds to a quantity of connecting surfaces. Alternatively, the first side rod 211, the second side rod 212, and the first connecting rod 213 are an integrally formed integrated structure, to increase the connecting strength of the first support member 20.

In the embodiment, the first connecting part 221 is arranged close to one end of the first side rod 211 away from the base 10, and the second connecting part 222 is arranged close to one end of the second side rod 212 away from the base 10. Compared with the configuration in which the first connecting part 221 is arranged close to one end of the first side rod 211 close to the base 10 and the second connecting part 222 is arranged close to one end of the second side rod 212 close to the base 10, when the second support member 30 moves away from the base 10 relative to the first support member 20 until it can no longer move, the lengths of the first support member 20 and the second support member 30 in the Z direction are longer. Similarly, when the second support member 30 moves close to the base 10 relative to the first support member 20 until it can no longer move, the lengths of the first support member 20 and the second support member 30 in the Z direction are shorter.

In other words, the first connecting part 221 is arranged close to one end of the first side rod 211 away from the base 10, and the second connecting part 222 is arranged close to one end of the second side rod 212 away from the base 10, so that the operation and maintenance robot 100 can extend to a sufficient height to perform operation and maintenance on all computing devices 300, and when the operation and maintenance robot is in a fully retracted state, the height of the operation and maintenance robot 100 is lower. Therefore, the operation and maintenance robot 100 can move more stably due to its low height during movement.

Of course, in other embodiments, the first connecting part 221 may be arranged not close to the end of the first side rod 211 away from the base 10, and the first connecting part 221 may be arranged in the middle of the first side rod 211, or at a position of the first side rod 211 close to the base 10. Similarly, the second connecting part 222 may be arranged not close to the end of the second side rod 212 away from the base 10, and the second connecting part 222 may be arranged in the middle of the second side rod 212, or at a position of the second side rod 212 close to the base 10.

In the embodiment, the first side rod 211 may include a first rod 211a and a second rod 211b, and the first rod 211a and the second rod 211b are arranged in parallel and fixedly connected. Surfaces of the first rod 211a and the second rod 211b toward the first avoidance groove 14 together form the first connecting surface 2111. It can be understood that the first side rod 211 in the embodiment includes two rods, thereby ensuring the strength of the first side rod 211. Of course, in other embodiments, the first side rod 211 may be only one rod, or may include a plurality of rods.

In the embodiment, the second side rod 212 may include a third rod 212a and a fourth rod 212b, and the third rod 212a and the fourth rod 212b are arranged in parallel and fixedly connected. Surfaces of the third rod 212a and the fourth rod 212b toward the first avoidance groove 14 together form the second connecting surface 2121. It can be understood that, the second side rod 212 in the embodiment includes two rods, thereby ensuring the strength of the second side rod 212. Of course, in other embodiments, the second side rod 212 may also be only one rod, or may also include a plurality of rods.

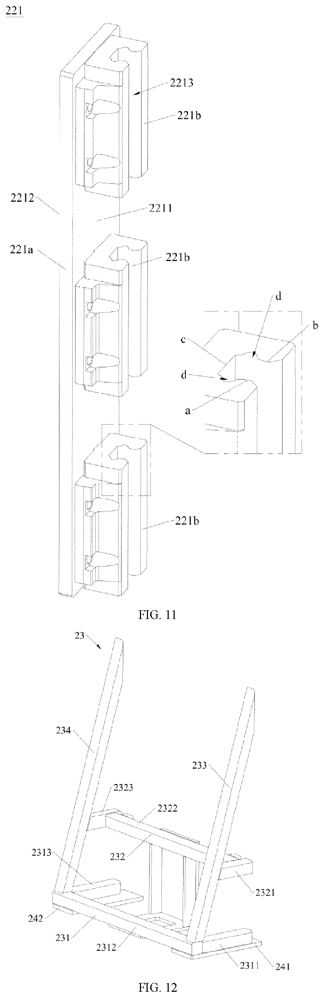

With reference to FIGS. 10 and 11, FIG. 11 is a structural diagram illustrating a first connecting part in the structure shown in FIG. 10.

The first connecting part 221 may include a body 221a and a connector 221b. The body 221a includes a first surface 2211 and a second surface 2212 disposed opposite to each other, the connector 221b is fixed to the first surface 2211 of the body 221a, and the second surface 2212 of the body 221a is connected to the first connecting surface 2111. The surface of the connector 221b facing away from the body 221a is provided with a sliding groove 2213. In the embodiment, a quantity of the connectors 221b is three, and the three connectors 221b are spaced from each other on the body 221a. Extension directions of the sliding grooves 2213 of the connectors 221b are same. The first sliding part 32a of the second support member 30 is slidably connected in the sliding groove 2213 of each connector 221b.

It is understandable that the three connectors 221b are spaced from each other, which not only ensures a length of engagement between the three connectors 221b and the first sliding part 32a (FIG. 3), thus allowing the second support member 30 to be stably slidably connected to the first support member 20, but also ensures that a contact area between the three connectors 221b and the first sliding part 32a is small enough, reducing the friction force therebetween during sliding. This enables the second support member 30 to move stably and smoothly relative to the first support member 20.

Of course, in other embodiments, the quantity of the connectors 221b may be one, two, or more than three. When there is one connector 221b, the length of the one connector 221b is same as or close to that of the body 221a. Alternatively, in other embodiments, the first connecting part 221 may also include only the connector 221b, without the body, and the connector b is directly fixed to the first connecting surface 2111.

In the embodiment, the sliding groove 2213 may include a first side wall a and a second side wall b disposed opposite to each other, and a bottom wall c connected between the first side wall a and the second side wall b. When the first sliding part 32a moves relative to the sliding groove 2213, the first sliding part 32a is restricted by the first side wall a and the second side wall b, which prevents the first sliding part 32a from tilting in the Y direction.

For example, the first side wall a and the second side wall b are provided with notches d. The notches d are configured to engage with the first sliding part 32a. When the first sliding part 32a moves relative to the sliding groove 2213, the first sliding part 32a is restricted by walls of the notches d, which prevents the first sliding part 32a from tilting in the X direction.

That is, the sliding groove 2213 in the embodiment can prevent the first sliding part 32a from tilting in the Y direction and the X direction, which ensures that the second support member 30 remains stable during movement. Of course, in other embodiments, the first side wall a and the second side wall b may also be not provided with notches.

It should be noted that in the embodiment, a structure of the second connecting part 222 is same as that of the first connecting part 221. The manner in which the second connecting part 222 engages with the second side rod 212 and the first sliding part 32a is also same as the manner in which the first connecting part 221 engages with the first side rod 211 and the first sliding part 32a, which will not be repeated. Of course, in other embodiments, the structure of the second connecting part 222 may also be different from that of the first connecting part 221.

With reference to FIGS. 9 and 12, FIG. 12 is a structural diagram illustrating an auxiliary support body in the structure shown in FIG. 9.

The first support member 20 may also include an auxiliary support body 23. The auxiliary support body 23 may include a base frame 231, a reinforcing frame 232, a first support rod 233, and a second support rod 234. The base frame 231 is fixed to the top surface 11 (FIG. 2), and is connected to one side of the first side rod 211 and one side of the second side rod 212 which face away from the connecting part 22. One end of the first support rod 233 is connected to the middle of the first side rod 211, and the other end is connected to a position of the base frame 231 away from the first side rod 211. One end of the second support rod 234 is connected to the middle of the second side rod 212, and the other end is connected to a position of the base frame 231 away from the second side rod 212. The reinforcing frame 232 is connected among the first support rod 233, the second support rod 234, the first side rod 211, and the second side rod 212. That is, the auxiliary support body 23 supports the first support body 21 of the first support member 20 in a triangular configuration, ensuring stability of the first support member 20.

It is understandable that the auxiliary support member 23 is arranged on one side of the first side rod 211 and one side of the second side rod 212 which face away from the connecting part 22, so that the auxiliary support member 23 does not interfere with the second support member 30 during movement of the second support member 30.

For example, the base frame 231 may include a first base rod 2311, a second base rod 2312, and a third base rod 2313 sequentially connected, and the first base rod 2311 and the third base rod 2313 are arranged in parallel. A first end of the first base rod 2311 and a first end of the third base rod 2313 that are away from the second base rod 2312, are respectively connected to the first side rod 211 and the second side rod 212. The other end of the first support rod 233 is connected to one end of the second base rod 2312, and the other end of the second support rod 234 is connected to the other end of the second base rod 2312.

The reinforcing frame 232 may include a first reinforcing rod 2321, a second reinforcing rod 2322, and a third reinforcing rod 2323, the first reinforcing rod 2321 is arranged in parallel to the third reinforcing rod 2323, and the second reinforcing rod 2322 is connected between the first reinforcing rod 2321 and the third reinforcing rod 2323. The first reinforcing rod 2321 is connected between the middle of the first support rod 233 and the first side rod 211, and is parallel to the first base rod 2311. The third reinforcing rod 2323 is connected between the middle of the second support rod 234 and the second side rod 212, and is parallel to the third base rod 2313. The reinforcing frame 232 is configured to reinforce the strength of the auxiliary support body 23.

It should be noted that when a component is connected to the first side rod 211, and the first side rod 211 includes at least two rods, the component may be connected to at least one of the at least two rods of the first side rod 211. When a component is connected to the second side rod 212, and the second side rod 212 includes at least two rods, the component may be connected to at least one of the at least two rods of the second side rod 212.

Of course, in other embodiments, the auxiliary support body 23 is not limited to the above descriptions. For example, the auxiliary support body may also include only a first support rod and a second support rod. The first support rod is connected between the middle and the top surface of the first side rod, and one end of the first support rod connected to the top surface is spaced a certain distance from one end of the first side rod connected to the top surface. The second support rod is connected between the middle and the top surface of the second side rod, and one end of the second support rod connected to the top surface is spaced a certain distance from one end of the second side rod connected to the top surface. Alternatively, the auxiliary support body may also include only one support rod, etc. Alternatively, all components of the auxiliary support body are an integrally formed integrated structure, and the shape of the auxiliary support body may be a shape other than the triangular shape, as long as the auxiliary support body can support the first support body.

Of course, in other embodiments, the first support member 20 may also not include the auxiliary support body.

As shown in FIGS. 9 and 12, in the embodiment, the first support member 20 may also include a first reinforcing plate 241 and a second reinforcing plate 242. The first reinforcing plate 241 is fixed to surfaces of the first side rod 211, the first base rod 2311 and a portion of the second base rod 2312 that are toward the base 10. The second reinforcing plate 242 is fixed to surfaces of the second side rod 212, the third base rod 2313 and a portion of the second base rod 2312 that are toward the base 10. The first side rod 211 and the second side rod 212 are fixed to the top surface 11 of the base 10 respectively by the first reinforcing plate 241 and the second reinforcing plate 242. The auxiliary support body 23 is fixed to the top surface 11 of the base 10 by the first reinforcing plate 241 and the second reinforcing plate 242.

It can be understood that, in the embodiment of the present application, the first reinforcing plate 241 fixes the first side rod 211 and the base frame 231 together, and then mounts them to the base 10, and the second reinforcing plate 242 fixes the second side rod 212 and the base frame 231 together, and mounts them to the base 10. That is, the first reinforcing plate 241 and the second reinforcing plate 242 integrate the first side rod 211, the second side rod 212 and the base frame 231 together as a whole, and secures the whole to the base 10, which effectively enhances the connection strength of the whole.

Of course, in other embodiments, the first reinforcing plate 241 and the second reinforcing plate 242 may also be an integrally formed integrated structure. That is, the integrated structure may be fixed to surfaces of the first side rod 211, the base frame 231 and the second side rod 212 toward the base 10.

In other embodiments, at least two of a reinforcing member 24, the auxiliary support body 23, and the first support body 21 may be an integrally formed integrated structure, which enhances the connection strength of the first support member 20 and ensures the stability of the operation and maintenance robot 100.

It is understandable that the structures of the two second support members 30 may be identical or different. In the embodiment, the architectures of the two first support members 30 are same. The following description will be made by taking one of the second support members 30 for example.

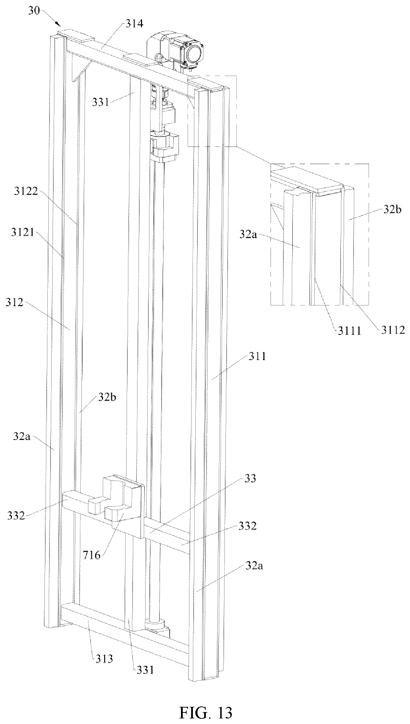

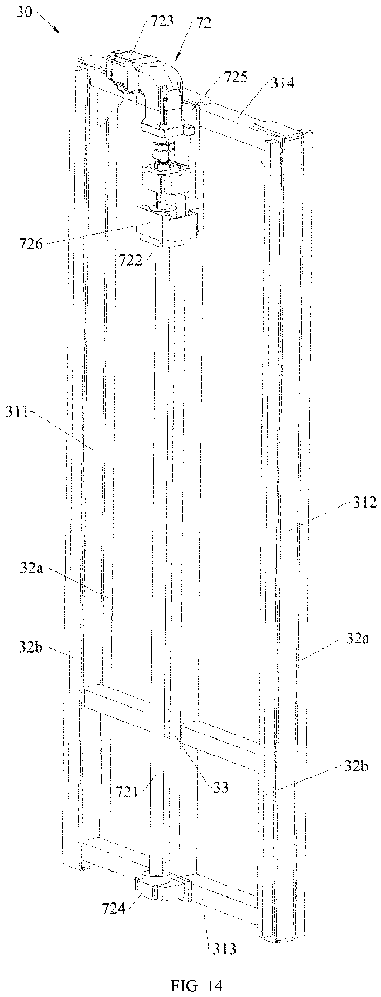

With reference to FIGS. 3, 13, and 14, FIG. 13 is a structural diagram illustrating a second support member and other parts of the operation and maintenance robot shown in FIG. 2; FIG. 14 is a structural diagram illustrating the structure shown in FIG. 13 from another perspective.

The second support body 31 of the second support member 30 may include a third side rod 311, a fourth side rod 312, a third connecting rod 313, and a fourth connecting rod 314. The third side rod 311 is arranged in parallel and spaced from the fourth side rod 312, the third connecting rod 313 is connected between a first end of the third side rod 311 and a first end of the fourth side rod 312, and the fourth connecting rod 314 is connected between a second end of the third side rod 311 and a second end of the fourth side rod 312. The first end of the third side rod 311 and the first end of the fourth side rod 312 are toward a same direction, and both toward the base 10, while the second end of the third side rod 311 and the second end of the fourth side rod 312 are toward a same direction, and both away from the base 10. In addition, the second support body 30 in the embodiment consists of several rod bodies, which are lighter than plate bodies. This can, to a certain extent, lower the center of gravity of the operation and maintenance robot 100, thereby increasing the stability during the movement and operation of the operation and maintenance robot 100.

In the embodiment, the third side rod 311 may include a first mounting surface 3111 and a second mounting surface 3112 disposed facing away from each other, the fourth side rod 312 includes a third mounting surface 3121 and a fourth mounting surface 3122 disposed facing away from each other, and the first mounting surface 3111 and the third mounting surface 3121 are toward a same direction. Quantities of the first sliding parts 32a and the second sliding parts 32b are two. The two first sliding parts 32a are respectively fixedly mounted on the first mounting surface 3111 and the third mounting surface 3121. The two second sliding parts 32b are respectively fixedly mounted on the second mounting surface 3112 and the fourth mounting surface 3122. One of the first sliding parts 32a engages with the first connecting part 221, and the other of the first sliding parts 32a engages with the second connecting part 222, thereby allowing the second support member 30 to move relative to the first support member 20. The two second sliding parts 32b are slidably connected to one side of the operation console 40, thereby allowing the operation console 40 to move relative to the second support member 30. The first mounting surface 3111 and the third mounting surface 3121 together form the first side surface, and the second mounting surface 3112 and the fourth mounting surface 3122 together form the second side surface. Alternatively, the first mounting surface 3111 and the third mounting surface 3121 may also be the first side surfaces, and the second mounting surface 3112 and the fourth mounting surface 3122 may also be the second side surfaces.

Understandably, in the embodiment, one first sliding part 32a is mounted on each of the third side rod 311 and the fourth side rod 312, so that the third side rod 311 and the fourth side rod 312 are slidably connected to the first side rod 211 and the second side rod 212 respectively by the corresponding first sliding part 32a. This allows forces on the second support member 30 during its movement relative to the first support member 20 to be more balanced, resulting in smoother movement.

Similarly, each of the two second sliding parts 32b is slidably connected to one side of the operation console 40. This allows forces on the operation console 40 during its movement relative to the second support member 30 to be more balanced, resulting in smoother movement.

It is understandable that the third side rod 311 and the fourth side rod 312 are respectively mounted with the first sliding part 32a and the second sliding part 32b. That is, the first sliding part 32a and the second sliding part 32b are connected to the second support body 31. Compared with the first sliding part 32a or the second sliding part 32b being indirectly connected to the second support body 31 respectively by other connectors, the structure in the embodiment is simpler, which may effectively achieve miniaturization of the operation and maintenance robot 100, reduce the weight of the second support member 30, and improve the smoothness of the movement of the operation and maintenance robot 100.

In addition, each of the first sliding part 32a and the second sliding part 32b is connected to sides of a corresponding side rod that face away from each other. In other words, the first side surface and the second side surface are disposed facing away from each other, so that the corresponding second support members 30 to be respectively connected to the first support member 20 and the operation console 40 on both sides of the second support member 30, resulting in a simple structure. Of course, in other embodiments, the first sliding part 32a and the second sliding part 32b may also be provided on two adjacent surfaces of the corresponding side rods. Correspondingly, positions of the first support body 21 disposed on the first connecting part 221 and the second connecting part 222 of the first support member 20 may also be adjusted accordingly.

Of course, in other embodiments, the second support member 31 may also include only the third side rod 311, without the fourth side rod, the third connecting rod and the fourth connecting rod. In this case, quantities of the first sliding part 32a and the second sliding part 32b are one, the first sliding part 32a and the second sliding part 32b are respectively connected to the first mounting surface 3111 and the second mounting surface 3112, the first sliding part 32a is slidably connected to the first connecting part 221 of the first support member 20, and the second sliding part 32b is slidably connected to the operation console 40. Alternatively, the second support body 31 may also be replaced by a plate body. Alternatively, a quantity of at least one of the third side rods 311 or the fourth side rods 312 is two or more. In this case, quantities of the first sliding parts 32a and the second sliding parts 32b correspond to a quantity of the mounting surfaces. Alternatively, the third side rod 311, the fourth side rod 312, the third connecting rod 313 and the fourth connecting rod 314 are an integrally formed integrated structure, to increase the connecting strength of the second support member 30.

The second support member 30 may also include a reinforcing frame 33, and the reinforcing frame 33 may be in a cross shape. The reinforcing frame 33 may include two opposite first connecting ends 331, and two second connecting ends 332 disposed opposite to each other. The two first connecting ends 331 are respectively connected to the third connecting rod 313 and the fourth connecting rod 314, and the two second connecting ends 332 are respectively connected to the third side rod 311 and the fourth side rod 312. The reinforcing frame 33 is configured to enhance the overall strength of the second support body 31.

Of course, in other embodiments, the specific shape of the reinforcing frame 33 is not limited to the above description. For example, the reinforcing frame 33 may be in a linear shape or other shapes, which is not limited in the embodiment of the present application.

It can be understood that the reinforcing frame 33 may be integrally formed with the second support body 31 as an integral structure, or may be fixed to the second support body 31.

Of course, in other embodiments, the second support member 30 may also not include the reinforcing frame.

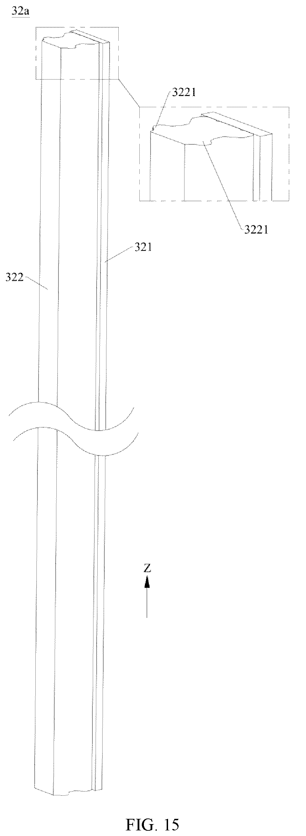

With reference to FIGS. 13 and 15, FIG. 15 is a structural diagram illustrating a first sliding part in the structure shown in FIG. 13.

The first sliding part 32a may include a first base plate 321 and a first slide strip 322, and the first slide strip 322 is fixed to the first base plate 321. It can be understood that the first sliding part 32a engages with the third side rod 311 in the same manner in which the first sliding part 32a engages with the fourth side rod 312, which are described by taking the first sliding part 32a engaging with the third side rod 311 for example. A surface of the first base plate 321 facing away from the first slide rod 322 is connected to the first mounting surface 3111. The first slide strip 322 is slidably connected in a sliding groove 2213 of the corresponding first connecting part 221.

In the embodiment, in the Z direction, the lengths of the first base plate 321 and the first slide strip 322 are same as or close to the length of the third side rod 311, to ensure that when the second support member 30 moves relative to the first support member 20, the first sliding part 32a of the second support member 30 can engage with the first connecting part 221 of the first support member 20, and the second support body 31 will not be separated from the first connecting part 221 of the first support body 21 when sliding relative to the first support member 20 due to a too short length of the first sliding part 32a.

It should be noted that the lengths of the first base plate 321 and the first slide strip 322 are close to the length of the third side rod 311, which means that the length of the first base plate 321 may be slightly greater or less than the length of the third side rod 311, and the length of the first slide strip 322 may be slightly greater or less than the length of the third side rod 311, as long as it is ensured that the operation console 40 can slide relative to the second support member 30 throughout the entire sliding travel.

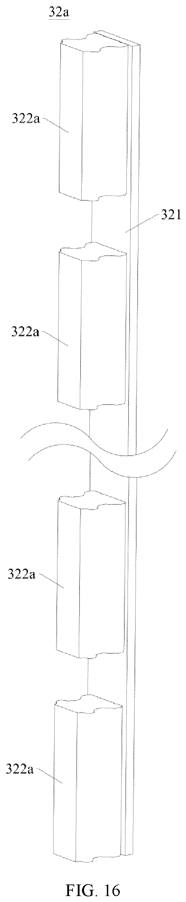

Of course, in other embodiments, as shown in FIG. 16, the first slide strip 322 may also be replaced by a plurality of shorter slide strips 322a that are spaced from each other, and the plurality of slide strips 322a are spaced from each other in the length direction of the first base plate 321. In such a configuration, there may be one or more connectors 221b of the first connecting part 221. Alternatively, in other embodiments, the first sliding part 32a may also include only the first slide strip 322, without the first base plate, and the first slide strip may be directly connected to the first mounting surface 3111.

It can be understood that, in other embodiments, the first sliding part may be connected to the first side rod. Correspondingly, the first connecting part may be connected to the third side rod. In order to ensure that the operation and maintenance robot can extend to a sufficient height when extending, and retract to a lower height when retracting, the first connecting part can be arranged close to one end of the third side rod close to the base.

As shown in FIGS. 11 and 15, in the embodiment, protrusions 3221 corresponding to the notches d on the first side wall a and the second side wall b of the sliding groove 2213 are provided on both sides of the first sliding strip 322. When the first sliding strip 322 is provided in a corresponding sliding groove 2213, the protrusions 3221 of the first sliding strip 322 are located in the corresponding notches d. Thus, when the first sliding part 32a moves relative to the sliding groove 2213, the protrusions 3221 engage with the notches d, which prevents the first sliding part 32a from tilting in the X direction. In addition, the first side wall a and the second side wall b can prevent the first sliding part 32a from tilting in the Y direction during movement. That is, engagement between the sliding groove 2213 and the first slide strip 322 ensures that the second support member 30 may avoid tilting in the Y direction and the X direction (FIG. 3) during movement, thereby ensuring stable movement of the second support member 30.

Of course, in other embodiments, protrusions may not be provided on both sides of the first slide strip 322.

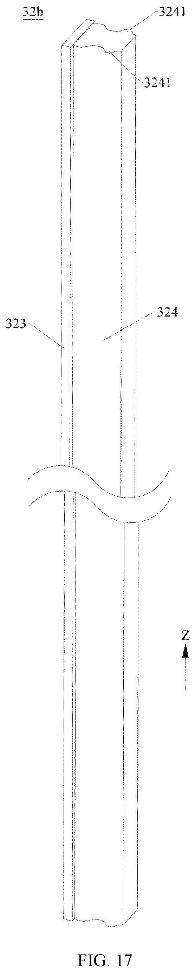

With reference to FIGS. 13 and 17, FIG. 17 is a structural diagram illustrating a second sliding part in the structure shown in FIG. 13.

The second sliding part 32b may include a second base plate 323 and a second slide strip 324. The second slide strip 324 is fixed to the second base plate 323. It can be understood that the second sliding part 32b engages with the third side rod 311 in the manner in which the second sliding part 32b engages with the fourth side rod 312. Taking engagement between the second sliding part 32b and the third side rod 311 for example, the surface of the second base plate 323 facing away from the second slide strip 324 is connected to the third mounting surface 3121. The second slide strip 324 is slidably connected to the operation console 40 (FIG. 3).

In the embodiment, in the Z direction, the lengths of the second base plate 323 and the second slide strip 324 is same as or close to the length of the third side rod 311, to ensure that the operation console 40 can engage with the second sliding part 32b of the second support member 30 during the process of moving relative to the second support member 30, and will not be separated from the second sliding part 32b of the second support body 31 during the process of sliding relative to the second support member 30 due to a too short length of the second sliding part 32b.

It should be noted that, the lengths of the second base plate 323 and the second slide strip 324 being close to the length of the third side rod 311 means that the length of the second base plate 323 may be slightly greater or less than the length of the third side rod 311, and the length of the second slide strip 324 may be slightly greater or less than the length of the third side rod 311. However, it is ensured that the operation console 40 can slide relative to the second support member 30 throughout the entire sliding travel.

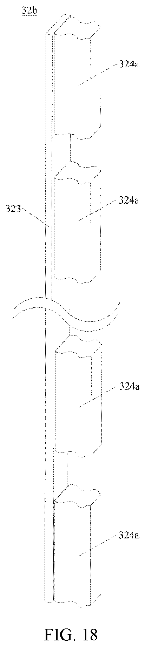

Of course, in other embodiments, as shown in FIG. 18, the second slide strip 324 may also be replaced by a plurality of shorter slide strips 324a that are spaced from each other, and the plurality of slide strips 324a are spaced from each other in the length direction of the second base plate 323. Alternatively, in other embodiments, the second sliding part 32b may also include only the second slide strip 324, without the second base plate, and the second sliding part 32b may be directly fixed to the third mounting surface 3121.

It can be understood that, in other embodiments, the second sliding part 32b may be fixedly disposed on the operation console 40. Correspondingly, a component of the operation console 40 that engages with the second sliding part 32b may be connected to the third side rod 311.

In the embodiment, protrusions 3241 are provided on both sides of the second slide strip 324. When the second slide strip 324 engages with related components of the operation console 40, the protrusions 3241 of the second slide strip 324 prevent the second sliding part 32b from tilting in the X direction, ensuring smooth movement of the operating movement 40.

Of course, in other embodiments, protrusions may not be provided on both sides of the second slide strip 324.

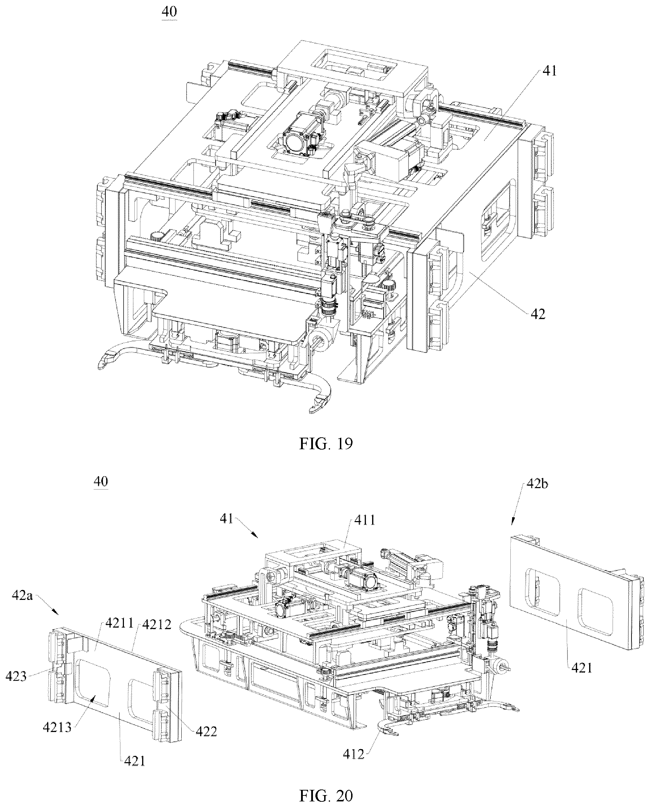

With reference to FIGS. 19 and 20. FIG. 19 is a structural diagram illustrating an operation console in the structure shown in FIG. 2; FIG. 20 is an exploded view illustrating the structure shown in FIG. 19.

The operation console 40 may include an operation main body 41 and a connecting plate assembly 42. The connecting plate assembly 42 may include a first connecting plate assembly 42a and a second connecting plate assembly 42b. The first connecting plate assembly 42a and the second connecting plate assembly 42b are respectively connected to opposite sides of the operation main body 41. The first connecting plate assembly 42a and the second connecting plate assembly 42b respectively correspond to the first side and the second side of the operation console 40. The operation console 40 is slidably connected to corresponding second support members 30 by the first connecting plate assembly 42a and the second connecting plate assembly 42b respectively.

As shown in FIG. 20, the operation main body 41 may include a body 411, an operation member 412, and a controller (not labeled in the figure). The operation member 412 is mounted on the body 411. The controller may be fixed to the body 411, and is configured to control the operation member 412 to operate a computing device 300. Opposite sides of the body 411 are respectively connected to the first connecting plate assembly 42a and the second connecting plate assembly 42b.

In the embodiment, the first connecting plate assembly 42a may include a mounting plate 421, a third connecting part 422, and a fourth connecting part 423. The mounting plate 421 includes a first surface 4211 and a second surface 4212 that are disposed opposite to each other, and the third connecting part 422 and the fourth connecting part 423 are spaced from each other on the first surface 4211. In combination with FIG.13, the third connecting part 422 is slidably connected to a second sliding part 32b of the third side rod 311 of one of the second support members 30, and the fourth connecting part 423 is slidably connected to a second sliding part 32b of the fourth side rod 312 of the same second support member 30. One side of the operation main body 41 is connected to the second surface 4212, to be slidably connected to one of the second support members 30 by the first connecting plate assembly 42a.

Structures of the third connecting part 422 and the fourth connecting part 423 are substantially same as that of the first connecting part 221, and the same part thereof will not be repeated. The difference is that quantities of connectors for the third connecting part 422 and the fourth connecting part 423 are two. The second slide strip 324 of the second sliding part 32b connected to the third side rod 311, is slidably connected in a sliding groove of the connector of the third connecting part 422. Similarly, the second slide strip 324 of the second sliding part 32b connected to the fourth side rod 312, is slidably connected in a sliding groove of the connector of the fourth connecting part 423.

In the embodiment, the structure of the second connecting plate assembly 42b is same as that of the first connecting plate assembly 42a, which will not be repeated. The third connecting part 422 of the second connecting plate assembly 42b is slidably connected to the second sliding part 32b of the third side rod 311 of the other of the second support members 30, and the fourth connecting part 423 of the second connecting plate assembly 42b is slidably connected to the second sliding part 32b of the fourth side rod 312 of the same second support member 30. The other side of the operation main body 41 is connected to the second surface 4212, to be slidably connected to the other second support member 30 by the second connecting plate assembly 42b.

Of course, in other embodiments, the third connecting part 422 and the fourth connecting part 423 of the first connecting plate assembly 42a may be directly connected to one side of the operation main body 41, and the third connecting part 422 and the fourth connecting part 423 of the second connecting plate assembly 42b may also be directly connected to the other side of the operation main body 41.

In the embodiment, a weight-reducing hole 4213 may also be formed in the mounting plate 421. A quantity of the weight-reducing holes 4213 may be one or more. When a quantity of the weight-reducing holes 4213 is a plurality, the shapes and sizes of the plurality of weight-reducing holes 4213 may be same or different. The weight-reducing hole 4213 is formed in the mounting plate 421, which may reduce the weight of the mounting plate 421, and lower the center of gravity of the operation and maintenance robot 100, thereby ensuring that the operation and maintenance robot 100 is more stable during movement. of course, in other embodiments, a weight-reducing hole may not be formed in the mounting plate 421.

With reference to FIG. 3, in the embodiment, the operation and maintenance robot 100 may also include a first drive assembly 71 and a second drive assembly 72. The first drive assembly 71 is configured to drive the second support member 30 to move relative to the first support member 20, such as moving close to or away from the base 10. The second drive assembly 72 is configured to operate the operation console 40 to move relative to the second support member 30, such as moving close to or away from the base 10.

In the embodiment, a quantity of the first drive assemblies 71 is two. One first drive assembly 71 is configured to drive the second support member 30a to move relative to the first support member 20a, and the other first drive assembly 71 is configured to drive the second support member 30b to move relative to the first support member 20b. It can be understood that, the second support members 30a and 30b are connected by the operation console 40 or the connecting plate 60, forming a whole. The two first drive assemblies 71 may be understood as respectively driving opposite sides of the whole. Compared with driving one side of the whole, forces on the whole are more balanced, which facilitates smoother movement of the whole.

Of course, in other embodiments, the quantity of the first drive assemblies 71 may also be one or more. When the quantity of the first drive assemblies 71 is one, the first drive assembly 71 may drive one of the second support members to move relative to a corresponding first support member. When the quantity of the first drive assemblies 71 is a plurality, a portion of the plurality of first drive assemblies may collectively drive one of the second support members to move relative to a corresponding first support member, and another portion of the plurality of first drive assemblies may collectively drive another second support member to move relative to a corresponding first support member.

With reference to FIG. 3, in the embodiment, a quantity of the second drive assemblies 72 is two. One second drive assembly 72 is close to a first side of the operation console 40, and is configured to drive the operation console 40 to move relative to the second support member 30a. The other second drive assembly 72 is close to a second side of the operation console 40, and is configured to drive the operation console 40 to move relative to the second support member 30b. It is understandable that the two second drive assemblies 72 respectively drive both sides of the operation console 40. Compared with one drive assembly driving one side of the operation console 40, forces on the operation console 40 are more balanced, which facilitates smooth movement of the operation console 40.

Of course, in other embodiments, a quantity of the second drive assemblies 71 may also be one or more. When the quantity of the second drive assemblies 71 is one, the second drive assembly 71 may drive a first side or second side of the operation console, so that the operation console moves relative to a corresponding second support member. When the quantity of the second drive assemblies 72 is a plurality, a portion of the plurality of second drive assemblies 72 may collectively drive the first side of the operation console so that the operation console moves relative to a corresponding second support member, and another portion of the plurality of second drive assemblies 72 may collectively drive the second side of the operation console so that the operation console moves relative to a corresponding second support assembly.

In the embodiment, the structures of the two first drive assemblies 71 and their engagement with the corresponding second support members 30 and the first support members 20 are same, which will be described by taking one of the first drive assemblies 71 for example.

With reference to FIGS. 3 and 10, the first drive assembly 71 may include a first screw rod 711, a first nut 712, and a first drive source 713. A first end of the first screw rod 711 is rotatably connected to a position of the first support member 20 close to the base 10, and a second end of the first screw rod 711 is rotatably connected to a position of the first support member 20 away from the base 10. The first nut 712 is fixed to the second support member 30 and rotatably connected to the first screw rod 711, and is located between a first end and a second end of the first screw rod 711. The first drive source 713 is connected to the first end of the first screw rod 711.

The first drive source 713 rotates to drive the first screw rod 711 to rotate. The first screw rod 711 engages with the first nut 712 to drive the second support member 30 to move up or down, thereby moving relative to the first support member 20. Of course, in other embodiments, the first drive source 713 may also be connected to the second end of the first screw rod 711.

The first end of the first screw rod 711 is rotatably connected to a position of the first support member 20 close to the base 10 by a first adapter member 714. For example, a portion of the first adapter member 714 may be fixed to the reinforcing frame 232 of the first support member 20, and another portion is rotatably connected to the first end of the first screw rod 711. The first end of the first screw rod 711 is rotatably connected to the first adapter member 714 by a bearing. The second end of the first screw rod 711 is rotatably connected to a position of the first support member 20 away from the base 10 by a second adapter member 715. For example, a portion of the second adapter member 715 may be fixed to the connecting rod 213, and another portion is rotatably connected to the second end of the first screw rod 711. The second end of the first screw rod 711 is rotatably connected to the second adapter member 715 by the bearing.

It can be understood that the manner in which both ends of the first screw rod 711 are fixed to the first support member 20 may also be a manner other than the above description, which is not limited in the embodiment of the present application. Alternatively, the first end of the first screw rod 711 is rotatably connected to the first adapter member 714 by a structure other than the bearing, and the second end of the first screw rod 711 is rotatably connected to the second adapter member 715 by a structure other than the bearing.

In the embodiment, the first screw rod 711 is located between the first side rod 211 and the second side rod 212. That is, the first side rod 211 and the second side rod 212 are respectively located on opposite sides of the first screw rod 711. This ensures that when the first screw rod 711 drives the second support member 30 to move relative to the first support member 20, the second support member 30 slides relative to the first side rod 211 and the second side rod 212, and forces on both sides of the second support member 30 in the Y direction are balanced, so that the second support member 30 moves more stably. Of course, in other embodiments, the first screw rod 711 may also be located at a position other than between the first side rod 211 and the second side rod 212.

In the embodiment, the first screw rod 711 is also located between the first support member 21 and the second support member 31. This ensures that the first screw rod 711, which drives the movement of the second support member 30, is arranged close to the second support member 31, which facilitates driving movement of the second support member 30. Of course, in other embodiments, the first screw rod 711 may also be located at a position other than between the first support body 21 and the second support body 31.

In the embodiment, as shown in FIGS. 10 and 13, the first nut 712 is connected to the second support member 30 by a third adapter member 716. For example, a portion of the third adapter member 716 may be connected to the reinforcing frame 33 of the second support member 30, while another portion may be fixedly connected to the first nut 712. The third connector 716 is connected to a surface of the reinforcing frame 33 toward the first support member 20, to facilitate engagement of the first nut 712 with the first screw rod 711.

It can be understood that the manner in which the first screw 712 is fixed to the second support member 30 may also be a manner other than the above description, which is not limited in the embodiment of the present application.

In the embodiment, as shown in FIGS. 2 and 10, the first drive source 713 is fixed to the auxiliary support body 23 of the first support member 20, and a portion of the first drive source 713 is housed in the base 10, and an output shaft of the first drive source 713 is connected to the first end by a transmission belt 717. That is, the first drive source 713 is indirectly connected to the first end of the first screw rod 711 by the transmission belt 717, so that the first drive source 713 provides a receiving space for the first drive source housed in the base 10. Compared with the first drive source being directly connected to the first end of the first screw rod 711, the embodiment not only ensures the neat appearance of the operation and maintenance robot 100 but also ensures that the first drive source 713 does not prevent the second support member 30 from moving into the second avoidance groove 15 of the base 10 when the second support member 30 moves toward the base 10, and in addition, facilitates miniaturization of the operation and maintenance robot 100. of course, in other embodiments, the first drive source 713 may also be connected to the first end of the first screw rod 711.

It can be understood that the first drive source 713 may be a motor, the first drive source 713 is electrically connected to a control board, and the control board drives the first drive source 713 to rotate, thereby driving the second support member 30 to move up or down relative to the first support member 20.

In the embodiment, the structures of the two second drive assemblies 72 and their engagement with the corresponding operation console 40 and the second support member 30 are same, which is described by taking the second drive assembly 72 that drives the first side of the operation console 40 for example.

As shown in FIGS. 3 and 14, the second drive assembly 72 may include a second screw rod 721, a second nut 722 and a second drive source 723. A first end of the second screw rod 721 is rotatably connected to a position of the second support member 30 close to the base 10, and a second end of the second screw rod 721 is rotatably connected to a position of the second support member 30 away from the base 10. The second nut 722 is connected to a first side of the operation console 40 and rotatably connected to the second screw rod 721, and is located between a first end and a second end of the second screw rod 721. The second drive source 723 is connected to the second end of the second screw rod 721.

The second drive source 723 rotates to drive the second screw rod 721 to rotate. The second screw rod 721 engages with the second nut 722 to drive the operation console 40 to move up or down, thereby moving relative to the second support member 30.

It is understandable that the second drive source 723 is connected to the second end of the second screw rod 721 to avoid interfering with movement of the second support member 30. Of course, in other embodiments, the second drive source 723 may also be connected to the first end of the second screw rod 721.

The first end of the second screw rod 721 is rotatably connected to a position of the first support member 20 close to the base 10 by a fourth adapter member 724. For example, the fourth adapter member 724 may be fixed to the third connecting rod 313 of the second support member 30, and the first end of the second screw rod 721 is rotatably connected to the fourth adapter member 724 by a bearing. The second end of the second screw rod 721 is rotatably connected to a position of the second support member 30 away from the second support member 30 by a fifth adapter member 725. For example, the fifth adapter member 725 may be fixed to the fourth connecting rod 314, and the second end of the second screw rod 721 is rotatably connected to the fifth adapter member 725 by a bearing.

It can be understood that the manner in which both ends of the second screw rod 721 are fixed to the second support member 30 may also be a manner other than the above description, which is not limited in the embodiment of the present application. Alternatively, the first end of the second screw rod 721 is rotatably connected to the fourth adapter member 724 by a structure other than the bearing, and the second end of the second screw rod 721 is rotatably connected to the fifth adapter member 725 by a structure other than the bearing.

In the embodiment, the second screw rod 721 is located between the third side rod 311 and the fourth side rod 312. That is, the third side rod 311 and the fourth side rod 312 are respectively located on opposite sides of the second screw rod 721. This ensures that when the second screw rod 721 drives the operation console 40 to move relative to the second support member 30, the operation console 40 slides relative to the third side rod 311 and the fourth side rod 312, and the forces on both sides of the operation console 40 in the Y direction are balanced, so that the operation console 40 moves more stably. Of course, in other embodiments, the second screw rod 721 may also be located at a position other than between the third side rod 311 and the fourth side rod 312.

In the embodiment, the second screw rod 721 is also located between the second support member 31 and the operation console 40, thereby ensuring that the second screw rod 721 that drives the operation console 40 to move is arranged close to the operation console 40, which facilitates driving the operation console 40 to move. Of course, in other embodiments, the second screw rod 721 may also be located at a position other than between the second support body 31 and the operation console 40.

In the embodiment, as shown in FIGS. 14 and 20, the second nut 722 is connected to a first side of the operation console 40 by the mounting plate 421 connected to the first connecting plate assembly 42a. Of course, in other embodiments, the second nut 722 may be directly connected to the first side of the operation console 40.

In the embodiment, the second nut 722 is connected to the mounting plate 421 by a sixth adapter member 726. The sixth adapter member 726 is connected to the surface of the mounting plate 421 facing away from the operation main body 41, so that the second nut 722 engages with the second screw rod 721.

It can be understood that the manner in which the second screw rod 722 is fixed to the mounting plate 421 may also be a manner other than the above description, which is not limited in the embodiment of the present application.

In the embodiment, the second drive source 723 is mounted on the fourth connecting rod 314 of the second support body 31, and the output shaft of the second drive source 723 is connected to the second end of the second screw rod 721. That is, the second drive source 723 is directly connected to the second end of the second screw rod 721 without needing an intermediary adapter, resulting in a simple connection structure. Of course, in other embodiments, the output shaft of the second drive source 723 may be connected to the second end of the second screw 721 by the transmission belt. That is, the second drive source 723 is indirectly connected to the first end of the second screw 721 by the transmission belt.

It can be understood that the second drive source 723 may be a motor. The second drive source 723 is electrically connected to a control board, and the control board drives the second drive source 723 to rotate, thereby driving the operation console 40 to move up or down relative to the second support member 30.

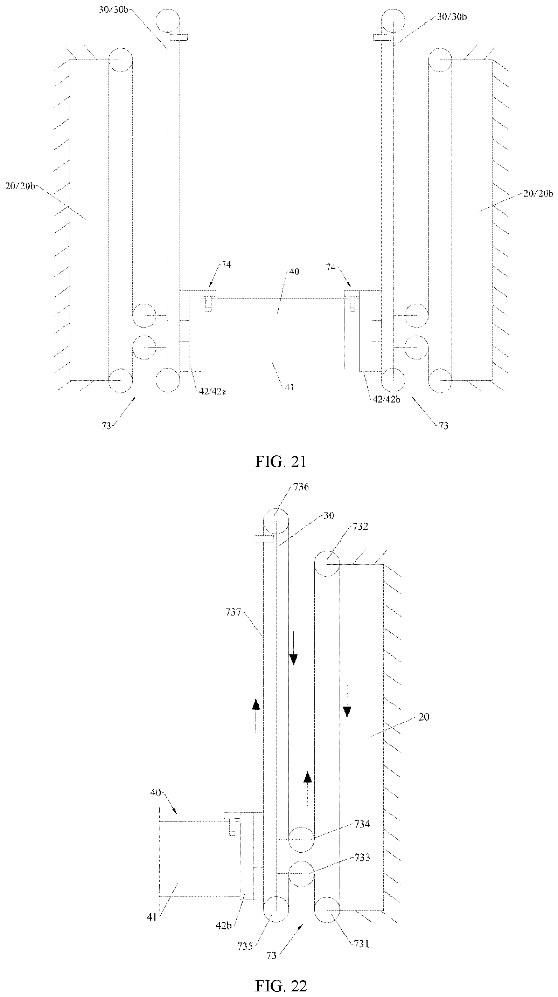

With reference to FIG. 21, FIG. 21 is a schematic diagram illustrating part of the structure of another operation and maintenance robot according to an embodiment of the present application.

The structure of the operation and maintenance robot 100 in the embodiment is substantially same as that of the operation and maintenance robot 100 in the embodiment shown in fig. 2, and the same part will not be repeated. the difference is that, the operation and maintenance robot 100 in the embodiment includes a third drive assembly 73 and a fourth drive assembly 74. the third drive assembly 73 is configured to drive the operation console 40 to move relative to the second support member 30 and to drive the second support member 30 to move relative to the first support member 20. The fourth drive assembly 74 is configured to drive the operation main body 41 to move relative to the connecting plate assembly 42.

The third drive assembly 73 drives the operation console 40 and the second support member 30 to move with low precision, while the fourth drive assembly 74 drives the operation console 40 to move with relatively high precision.

It can be understood that the operation console 40 is slidably connected to the second support member 30, and the third drive assembly 73 drives the second support member 30 to move relative to the first support member 20, and also drives the operation console 40 to move relative to the first support member 20. Therefore, the third drive assembly 73 is configured to drive the operation console 40 to move relative to the second support member 30 and to drive the second support member 30 to move relative to the first support member 20, which can be understood that the third drive assembly 73 drives the operation console 40 to move in the height direction of the operation and maintenance robot 100. The fourth drive assembly 74 drives the operation main body 41 to move relative to the connecting plate assembly 42, such as driving the operation main body 41 to move the connecting plate assembly 42 in the length of the Z direction. The third drive assembly 73 drives the operation console 40 to move with a long travel distance. The fourth drive assembly 74 drives the operation main body 41 to move with a short travel distance.

It can be understood that the third drive assembly 73 is configured to drive the operation console 40 close to a target position. For example, the operation main body 41 of the operation console 40 is close to the target position. The fourth drive assembly 74 is configured to move the operation main body 41 of the operation console 40 close to the target position to the target position. Since the travel distance required to drive the operation main body 41 to be close to the target position is long, and the travel distance required to move the operation main body 41 to be close to the target position is short, the third drive assembly 73 with low precision drives the operation main body 41 with the long travel distance, and the fourth drive assembly 74 with high precision drives the operation main body 41 with the short travel distance. Compared with driving with the long travel distance by using the drive assembly with high precision, the configuration can effectively reduce the cost of the operation and maintenance robot 100.

It should be noted that, the third drive assembly 73 drives the operation console 40 close to the target position in various cases. In a first case, the third drive assembly 73 drives the operation console 40 to move relative to the second support component 30, so that the operation console is close to the target position. In a second case, the third drive assembly 73 drives the second support member 30 to move relative to the first support member 20, so that the second support member 30 drives the operation console 40 to move close to the target position. In a third case, the third drive assembly 73 first drives the operation console 40 to move relative to the second support assembly 30, and then drives the second support assembly 30 to move relative to the first support member 20, so as to move the operation console 40 close to the target position. In a fourth case, the third drive assembly 73 first drives the second support member 30 to move relative to the first support member 20 to drive the operation console 40 to move, and then drives the operation console 40 to move relative to the second support member 30, so that the operation console 40 is close to the target position.

In the embodiment, a quantity of the third drive assemblies 73 is two. One third drive assembly 73 is close to a first side of the operation console 40, and is configured to drive the operation console 40 to move relative to the second support member 30a and to drive the second support member 30a to move relative to the first support member 20a. The other third drive assembly 73 is located close to a second side of the operation console 40, and is configured to drive the operation console 40 to move relative to the second support member 30b and to drive the second support member 30b to move relative to the first support member 20b. The two third drive assemblies 73 drive both sides of the operation console 40 or both sides of the whole constituted by the operation console 40 and the two second support members 30. Compared with driving one side of the operation console 40 or one side of the whole, the configuration makes forces on the operation console 40 or the whole more balanced, which facilitates smooth movement of the operation console 40 or the whole.

Of course, in other embodiments, a quantity of the third drive assemblies 73 may also be one or more. When the quantity of the third drive assemblies 73 is one, the third drive assembly 73 may drive the first side (or second side) of the operation console, so that the operation console moves relative to a corresponding second support member and the corresponding second support member moves relative to a corresponding first support member. When the quantity of the third drive assemblies 73 is a plurality, a portion of the plurality of third drive assemblies 73 may collectively drive the first side of the operation console 40, so that the operation console moves relative to the corresponding second support member and the second support member moves relative to the corresponding first support member; another portion of the plurality of first drive assemblies 71 may collectively drive the second side of the operation console, so that the operation console moves relative to a corresponding second support member 30 and the second support member moves relative to a corresponding first support member.

As shown in FIG. 21, in the embodiment, a quantity of the fourth drive assemblies 74 is two. One fourth drive assembly 74 is connected between the first connecting plate assembly 42a and the operation main body 41, and is configured to drive the operation main body 41 to move relative to the first connecting plate assembly 42a. The other fourth drive assembly 74 is connected between the second connecting plate assembly 42b and the operation main body 41, and is configured to drive the operation main body 41 to move relative to the second connecting plate assembly 42b. The two fourth drive assemblies 74 respectively drive both sides of the operation main body 41. Compared with driving one side of the operation main body 41, the configuration makes forces more balanced due to the forces on both sides, which facilitates smooth movement of the operation main body 41.

Of course, in other embodiments, the quantity of the fourth drive assemblies 74 may also be one or more. When the quantity of the fourth drive assemblies 74 is one, the fourth drive assembly 74 may drive one side of the operation main body 41, so that the operation main body 41 moves relative to the connecting plate assembly 42. When the quantity of the fourth drive assemblies 74 is a plurality, a portion of the plurality of fourth drive assemblies 74 may collectively drive one side of the operate main body 41, and another portion of the plurality of fourth drive assemblies 74 may collectively drive the other side of the operation main body 41, so that the operation main body 41 moves relative to the connecting plate platform 42.

In the embodiment, structures of the two third drive assemblies 73 and their engagements with the corresponding second support members 30 and the first support members 20 are same, which is described by taking the third drive assembly 73 that drives the second side of the operation console 40 for example.

With reference to FIG. 22, FIG. 22 is a schematic diagram illustrating part of the structure shown in FIG. 21.

The third drive assembly 73 may include a first pulley 731, a second pulley 732, a third pulley 733, a fourth pulley 734, a fifth pulley 735, a sixth pulley 736, a transmission member 737, and a first power source (not shown in the figure).

The first pulley 731 is mounted on one end of the first support member 20 close to the base, the second pulley 732 is mounted on one end of the first support member 20 away from the base, the third pulley 733 and the fourth pulley 734 are mounted adjacent to each other on one side of the second support member 30 toward the first support member 20, the third pulley 733 is arranged close to the first pulley 731 relative to the fourth pulley 734, the fifth pulley 735 is mounted on one end of the second support member 30 close to the base, and the sixth pulley 736 is mounted on one end of the second support member 30 away from the base.

A first end of the transmission member 737 is located between the first pulley 731 and the third pulley 733, and a second end of the transmission member 737 is connected to the first end of the transmission member 737 after sequentially wrapping around the first pulley 731, the second pulley 732, the fourth pulley 734, the sixth pulley 736, the fifth pulley 735, and the third pulley 733. when the operation and maintenance robot 100 is in a fully retracted state, the second side of the operation console 40 is fixedly connected to the transmission member 737, and is arranged close to the fifth pulley 735. The first power source is connected to the first pulley 731.

In an embodiment, the first end of the transmission member 737 may also be connected to the second side of the operation console 10, and the second end of the transmission member 737 is connected to the second end of the operation console 10 after sequentially wrapping around the fifth pulley 735, the third pulley 733, the first pulley 731, the second pulley 732, the fourth pulley 734, and the sixth pulley 736. The first end and the second end of the transmission member 737 are respectively connected to upper and lower portions of the second side of the operation console 10.

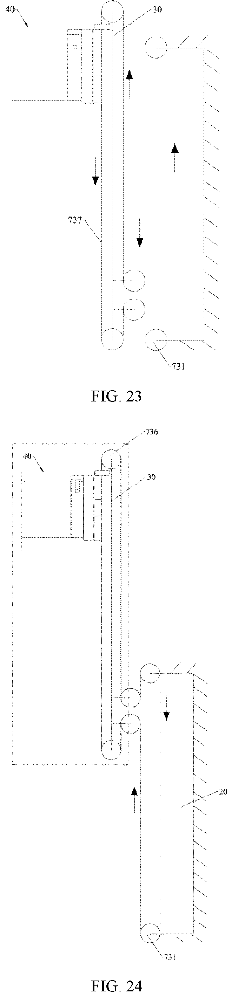

It can be understood that the movement of the operation console 40 relative to the second support member 30 is referred to as first-stage lifting and lowering. For example, as shown in FIGS. 22 and 23, movement of the operation console 40 within an entire travel range from the position in FIG. 22 to the position in FIG. 23, or within an entire travel range from the position in FIG. 23 to the position in FIG. 22, is considered as the first-stage lifting and lowering.

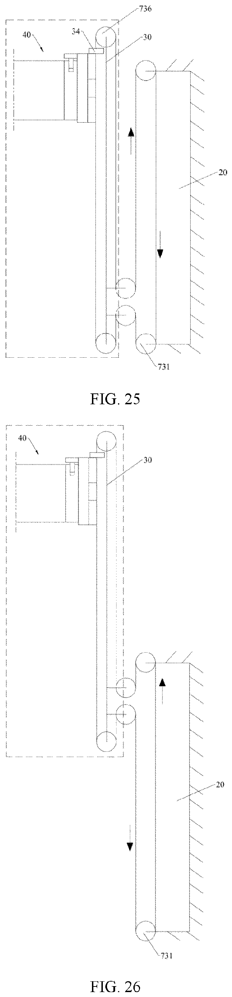

The movement of the second support member 30 relative to the first support member 20 is referred to as second-stage lifting and lowering. As shown in FIGS. 23 and 24, the movement of the second support member 30 within an entire travel range from the position shown in FIG. 23 to the position shown in FIG. 24, or the movement within an entire travel range from the position shown in FIG. 24 to the position shown in FIG. 23, is referred to as the second-stage lifting and lowering.
as shown in fig. 22, when the operation and maintenance robot 100 performs the first-stage lifting and lowering, the first power source may drive the first pulley 731 to rotate clockwise, which in turn drives the transmission member 737 to rotate clockwise, thereby driving the operation console 40 to move upward relative to the second support member 30. as shown in fig. 23, the first power source may drive the first pulley 731 to rotate counterclockwise, which in turn drives the transmission member 737 to rotate counterclockwise, thereby driving the platform 40 to move downward relative to the second support member 30.
as shown in fig. 25, when the operation console 40 moves relative to the second support member 30 to be close to the sixth pulley 736, the first power source continues drives the first pulley 731 to rotate clockwise. when the operation console 40 stops moving relative to the second support member 30, the operation and maintenance robot 100 enters the second-stage lifting and lowering. The operation console 40 and the second support member 30 as a whole move upward relative to the first support member 20 (as shown in FIG. 24). As shown in FIG. 26, when the operation and maintenance robot 100 is in the second-stage lifting and lowering, if the first power source drives the first pulley 731 to rotate counterclockwise, the operation console 40 and the second support member 30 as a whole move downward relative to the first support member 20, until the second support member 30 can no longer move downward. In this case, the second support member 30 and the first support member 20 act as a whole, and the operation and maintenance robot 100 transitions from the second-stage lifting and lowering to the first-stage lifting and lowering. The operation console 40 moves downward relative to the second support member 30 (as shown in FIG. 23).

It should be noted that, as shown in FIG. 25, the second support member 30 is provided with a first position-limiting member 34 close to the sixth pulley 736. When the operation console 40 moves relative to the second support member 30 to be close to the sixth pulley 736, the operation console 40 contacts the first position-limiting member 34, and the first position-limiting member 34 prevents the operation console 40 from continuing moving upward relative to the second support member 30, so that the operation console 40 stops moving relative to the second support member 30. If the first power source continues driving the first pulley 731 to rotate clockwise, the operation console 40 and the second support member 30 can only move upward relative to the first support member 20, to achieve continued upward movement of the operation console 40.

The third drive assembly 73 in the embodiment includes only one first power source. The two-stage lifting and lowering of the operation and maintenance robot 100 is achieved by the one first power source, which simplifies the structure of the third drive assembly 73 in the embodiment of the present application, thereby effectively reducing cost, compared with the solution in which the two-stage lifting and lowering of the operation and maintenance robot 100 is achieved by different first power sources respectively.

Of course, in other embodiments, a quantity of the pulleys included in the third drive assembly 73 is not limited to six, and may be greater than six. For example, the quantity of the pulleys may be 7, 8, 10, etc.

In the embodiment, the first power source may be, for example, a motor. The first power source is electrically connected to a control board, and the control board drives the first power source to rotate, thereby driving the operation console 40 to move up or down.

The transmission member 737 may, for example, be a transmission rope, a transmission belt, a belt, a chain, or other components capable of transmitting power.

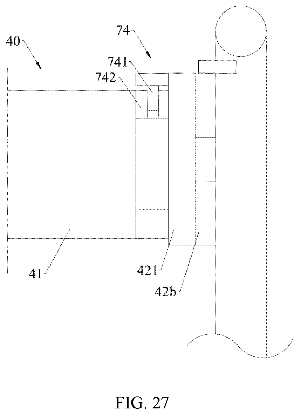

With reference to FIGS. 21 and 27, FIG. 27 is a schematic diagram illustrating part of the structure shown in FIG. 23.

In the embodiment, the structures of the two fourth drive assemblies 74 and their manners of engagement with the corresponding operation main bodies 41 and the connecting plate assemblies 42 are same, which will be described by taking the fourth drive assembly 74 connected between the operation main body 41 and the second connecting plate assembly 42b for example.

The fourth drive assembly 74 may include a fine adjustment lead screw 741, a third nut 742, and a second power source (not shown in the figure). The fine adjustment lead screw 741 is rotatably connected to the third nut 742, and the second power source is connected to the fine adjustment lead screw 741. The fine adjustment lead screw 741 is fixed to the mounting plate 421 of the second connecting plate assembly 42b, and the third nut 742 is fixed to the operation main body 41. The second power source is configured to drive the fine adjustment lead screw 741 to rotate, thereby driving the operation main body 41 to move up or down, to move the operation main body 41 to a target position.

In the embodiment, the travel distance of the fourth drive assembly 74 driving the operation body 41 to move is short, which is beneficial to cost reduction.

In the embodiment, the second power source may be, for example, a motor. The second power source is electrically connected to the control board, and the control board drives the first power source to rotate, thereby driving the operation main body 41 to move up or down.

Of course, in other embodiments, the structure of the fourth drive assembly 74 is not limited to the above description. The fourth drive assembly 74 may also be a combination of other structures working together in different manners, as long as it can move the operation main body 41 to the target position.

In the embodiment, the operation and maintenance robot 100 may also include a guide assembly. the guide assembly includes a slider and a sliding groove. the slider is fixedly connected to the operation main body 41, and the sliding groove is formed in the mounting plate 421 of the second connecting plate assembly 42b, and the slider is located in the sliding groove. When the operation main body 41 moves up or down, the slider is slidably connected in the sliding groove, to ensure that the operation main body 41 does not skew during its movement.

Of course, in other embodiments, the slider is fixedly connected to the mounting plate 421 of the second connecting plate assembly 42b, and the sliding groove is formed in the operation main body 41. In other embodiments, the guide assembly is not limited to the above description, as long as it can achieve the guidance of the operation main body 41.

It is understandable that a quantity of the guide components may be one or more. When the quantity of guide assemblies is a plurality, a portion of the guide assemblies is arranged between the operation main body 41 and the second connecting plate assembly 42b, and another portion of the guide assemblies is arranged between the operation main body 41 and the second connecting plate assembly 42b.

It should be noted that, where there is no conflict, embodiments and features in the embodiments in the present application can be combined with each other. A combination of features in different embodiments is also within the scope of protection of the present application. In other words, the plurality of embodiments described above can be combined arbitrarily according to actual needs.

It should be noted that all the accompanying drawings mentioned above are illustrative examples of the embodiments of the present application and do not represent an actual size of the product. A dimensional proportion relation among components in the accompanying drawings are not intended to limit the actual product in the embodiments of the present application.

The above are only part of embodiments and implementations of the present application. The scope of protection of the present application is not limited thereto. Those skilled in the art can easily think of variations or substitutions within the technical scope disclosed in the present application, all of which should be covered within the scope of protection of the present application. Therefore, the protection scope of the present application shall be subject to the protection scope of the claims.

## Claims

1. An operation and maintenance robot, comprising:
a base;
a first support member, comprising a first support body and a connecting part, wherein the connecting part is fixedly disposed on the first support body, and the first support body is fixed to the base;
a second support member, comprising a second support body, a first sliding part and a second sliding part, wherein the second support body comprises a first side surface and a second side surface, the first sliding part is fixedly disposed on the first side surface, the second sliding part is fixedly disposed on the second side surface, and the first sliding part is slidably connected to the connecting part, to enable the second support member to be close to or away from the base relative to the first support member; and
an operation console, slidably connected to the second sliding part, capable of being close to or away from the base relative to the second support member.

2. The operation and maintenance robot according to claim **1,** wherein the first side surface and the second side surface are disposed facing away from each other.

3. The operation and maintenance robot according to claim 1 or 2, wherein the first support body comprises a first side rod, a second side rod and a first connecting rod sequentially connected, the first side rod is parallel to the second side rod, one end of the first side rod and one end of the second side rod that are away from the first connecting rod are fixed to the base, the connecting part comprises a first connecting part and a second connecting part, the first connecting part is fixedly disposed on the first side rod, the second connecting part is fixedly disposed on the second side rod, a quantity of the first sliding parts is two, one of the first sliding parts is slidably connected to the first connecting part, and the other of the first sliding parts is slidably connected to the second connecting part.

4. The operation and maintenance robot according to any one of claims 1 to 3, wherein quantities of the first support members and the second support members are two, the two first support members are disposed opposite to each other and spaced from each other, the two second support members correspond to the two first support members one to one, and are located between the two first support members, the operation console is located between the two second support members, and opposite sides of the operation console are respectively slidably connected to the corresponding second support members.

5. The operation and maintenance robot according to any one of claims 1 to 4, further comprising a first drive assembly and a second drive assembly, wherein the first drive assembly drives the second support body to be close to or away from the base relative to the first support body, and the second drive assembly drives the operation console to be close to or away from the base relative to the second support body.

6. The operation and maintenance robot according to claim 5, wherein the first drive assembly comprises a first screw rod, a first nut, and a first drive source, a first end of the first screw rod is rotatably connected to one end of the first support member close to the base, a second end of the first screw rod is rotatably connected to one end of the first support member away from the base, the first nut is fixed to the second support member and rotatably connected to the first screw rod, and the first drive source is connected to the first end of the first screw rod.

7. The operation and maintenance robot according to any one of claims 1 to 4, comprising an operation main body and a connecting plate assembly, wherein the operation main body is slidably connected to the second sliding part by the connecting plate assembly, the operation and maintenance robot further comprises a third drive assembly and a fourth drive assembly, the third drive assembly drives the operation console to move relative to the second support body, and drives the second support body to move relative to the first support body, and the fourth drive assembly drives the operation main body of the operation console to move relative to the second support body.

8. The operation and maintenance robot according to claim 7, wherein the third drive assembly comprises a first pulley, a second pulley, a third pulley, a fourth pulley, a fifth pulley, a sixth pulley, a transmission member, and a first power source, the first pulley is mounted on one end of the first support member close to the base, the second pulley is mounted on one end of the first support member away from the base, the third pulley and the fourth pulley are mounted adjacent to each other on one side of the second support member toward the first support member, the third pulley is arranged close to the first pulley relative to the fourth pulley, the fifth pulley is mounted on one end of the second support member close to the base, and the sixth pulley is mounted on one end of the second support member away from the base; a first end of the transmission member is located between the first pulley and the third pulley, a second end of the transmission member is connected to the first end of the transmission member after sequentially wrapping around the first pulley, the second pulley, the fourth pulley, the sixth pulley, the fifth pulley, and the third pulley, a first side of the operation console is fixedly connected to the transmission member, and the first transmission source is connected to the first pulley.

9. The operation and maintenance robot according to claim 6 or 8, wherein the first screw rod or the transmission member is located between the first connecting part and the second connecting part.

10. The operation and maintenance robot according to any one of claims 1 to 9, wherein the base comprises a top surface and a bottom surface disposed facing away from each other, a first avoidance groove is formed in the top surface, the first avoidance groove is located between the two first support members, and the operation console is movable into the first avoidance groove.

11. The operation and maintenance robot according to claim 10, wherein two second avoidance grooves are formed in the top surface, one of the two second avoidance grooves is located between one of the first support members and the first avoidance groove, and is in communication with the first avoidance groove, and the other of the two second avoidance grooves is located between the other of the first support members and the first avoidance groove, and is in communication with the first avoidance groove; and a portion of the second support member is movable into a corresponding second avoidance groove.

12. An operation and maintenance robot, comprising:
a base, comprising a top surface and a bottom surface disposed facing away from each other, wherein a first avoidance groove is formed in the top surface and two second avoidance grooves, and the two second avoidance grooves are respectively located on opposite sides of the first avoidance groove, and are in communication with the first avoidance groove;
two first support members, each located on one side of each of the two second avoidance grooves, each side being away from the first avoidance groove, wherein each of the two first support members comprises a first support body and a connecting part, the connecting part is fixedly disposed on the first support body, and the first support body is fixed to the top surface;
two second support members, each disposed opposite to a respective one of the two second avoidance grooves; wherein each of the two second support member comprises a second support body, a first sliding part and a second sliding part, the second support body comprises a first side surface and a second side surface disposed facing away from each other, the first sliding part is fixedly disposed on the first side surface, and the second sliding part is fixedly disposed on the second side surface; the first sliding part of one of the second support members is slidably connected to a connecting part of one of the first support members, and the first sliding part of the other of the second support members is slidably connected to a connecting part of the other of the first support member, to enable the two second support members to be close to or away from the base relative to the two first support members, respectively, and portions of the two second support members are movable into corresponding second avoidance grooves; and
an operation console, wherein both sides of the operation console are respectively connected to the second sliding parts of the two second support members, the operation console is movable close to or away from the base relative to the two support members, and the operation console is movable into the first avoidance groove.
